# EUROPEAN PATENT SPECIFICATION

(11) **EP 3 674 096 B1**
(45) Date of publication and mention of the grant of the patent: **01.03.2023**
(21) Application number: 18860283.3
(22) Date of filing: 13.08.2018
(51) Int. Cl.: B41C 1/10, G03F 7/00, G03F 7/11, G03F 7/32

(54) **LITHOGRAPHIC PRINTING PLATE PRECURSOR AND LITHOGRAPHIC PRINTING PLATE FABRICATION METHOD**
LITHOGRAPHISCHER DRUCKPLATTENVORLÄUFER UND VERFAHREN ZUR HERSTELLUNG VON LITHOGRAPHISCHEN DRUCKPLATTEN
PRÉCURSEUR DE PLAQUE D'IMPRESSION LITHOGRAPHIQUE ET PROCÉDÉ DE FABRICATION DE PLAQUE D'IMPRESSION LITHOGRAPHIQUE

(30) Priority: 29.09.2017 JP 2017190836
(43) Date of publication of application: 01.07.2020
(73) Proprietor: FUJIFILM Corporation, Tokyo 106-8620 (JP)
(72) Inventor: ARAKI, Kenjiro, Haibara-gun Shizuoka 421-0396 (JP); KUDO, Kotaro, Haibara-gun Shizuoka 421-0396 (JP)
(74) Representative: Hoffmann Eitle
(86) International application number: PCT/JP2018/030246
(87) International publication number: WO 2019/064974

(56) References cited:
- EP-A2- 2 042 306
- JP-A- S5 532 086
- JP-A- 2007 272 143
- JP-A- 2014 081 528
- JP-A- 2015 519 610
- US-A1- 2017 114 158
- US-A1- 2017 217 149

## Description

The present disclosure relates to a lithographic printing plate precursor and a method of producing a lithographic printing plate.

A lithographic printing plate is typically formed of a lipophilic image area that receives ink and a hydrophilic non-image area that receives dampening water in the printing process.

Lithographic printing is a method of printing an image by setting a lipophilic image area of a lithographic printing plate as an ink receiving unit and a hydrophilic non-image area of the lithographic printing plate as a dampening water receiving unit (ink non-receiving unit) using the property in which water and oily ink repel each other, causing a difference in adhesiveness of ink to the surface of the lithographic printing plate, allowing the ink to be impressed only on an image area, and transferring the ink to a printing medium such as paper.

Currently, in a plate-making step of producing a lithographic printing plate from a lithographic printing plate precursor, image exposure has been performed using a computer-to-plate (CTP) technology. That is, the image exposure is performed by directly scanning and exposing a lithographic printing plate precursor using a laser or a laser diode without using a lith film.

Further, with a growing interest in the global environment, environmental issues related to a waste liquid associated with wet treatments such as a development treatment have been highlighted in regard to plate-making for a lithographic printing plate precursor. Along with this, it is desired to simplify the development treatment or not to perform the development treatment. As one of a simple development treatment, a method referred to as "on-press development" has been suggested. The on-press development is a method of image-exposing a lithographic printing plate precursor, attaching the lithographic printing plate precursor to a printing press without performing a wet development treatment of the related art, and then removing a non-image area of an image recording layer, at an initial stage of a typical printing step.

As lithographic printing plate precursors of the related art, those described in JP2015-519610A or JP2012-139921A have been known.

After exposure, a lithographic printing plate precursor is developed (treated) in order to remove a non-image area of an image recording layer. The lithographic printing plate precursor is typically designed such that a water-soluble overcoat layer or a water-soluble oxygen-impermeable barrier layer is disposed on the image recording layer. This water-soluble overcoat layer is used to ensure higher sensitivity of the image recording layer.

Such lithographic printing plate precursors are typically transported after production in a stack of several tens or several hundreds of individual precursors. In order to prevent a surface of the image recording layer from being scratched, an interleaf is generally inserted between precursors. However, regardless of the presence of the interleaf, there is a concern that the surface of the water-soluble overcoat layer is scratched during the transport operation (for example, during removal of the interleaf using an automated plate loader) so that the sensitivity of the scratched area may be degraded.

Further, the present inventors have found that since the lithographic printing plate precursor described in JP2015-519610A includes a water-soluble overcoat layer as an outermost layer, the lithographic printing plate precursor has excellent scratch resistance, but the developability of the lithographic printing plate is not sufficient.
EP 2 042 306 A2 relates to a planographic printing plate precursor having an intermediate layer and an image forming layer in this order on a support, wherein the intermediate layer comprises at least one copolymer comprising one of three specific structural units. Unit (1) comprises the moiety L₁-(CO₂H)ₙ , unit (2) comprises a carboxylate and a counterion (moiety "XM") and unit (3) comprises a substituent having 0-30 carbon atoms, provided that it is not a carboxy group and is not (XM) as in Formula (2). When the planographic printing plate precursor has a polymerizable negative image forming layer, a protective layer is preferably provided on the image forming layer for the purpose of preventing the introduction of low molecular weight compounds in the air. The protective layer preferably contains polyvinyl alcohol, fine particles composed of an organic resin, and mica particles.
US 2017/0217149 A1 relates to a negative-working infrared radiation-sensitive lithographic printing plate precursor which can be imaged and developed on-press to provide a lithographic printing plate. Such precursor has an initiator composition that contains a mixture of specific iodonium compounds.

An object to be achieved by an embodiment of the present invention is to provide a lithographic printing plate precursor which has excellent scratch resistance and developability.

An object to be achieved by another embodiment of the present invention is to provide a method of producing a lithographic printing plate obtained by using the lithographic printing plate precursor.

This object is solved by the on-press development type lithographic printing plate precursor and the method of producing a lithographic printing plate as defined in the claims.

According to an embodiment of the present invention, it is possible to provide a lithographic printing plate precursor which has excellent scratch resistance and developability.

Further, according to another embodiment of the present invention, it is possible to provide a method of producing a lithographic printing plate obtained by using the lithographic printing plate precursor.

### BRIEF DESCRIPTION OF THE DRAWINGS

Fig. 1 is a graph showing an example of an alternating waveform current waveform diagram used for an electrochemical roughening treatment in production of a support E.
Fig. 2 is a side view illustrating an example of a radial cell (electrolytic cell) in an electrochemical roughening treatment performed using an alternating current in production of the support E.

Hereinafter, the contents of the present disclosure will be described in detail. The description of constituent elements below is made based on representative embodiments of the present disclosure in some cases, but the present disclosure is not limited to such embodiments.

Further, in the present specification, the numerical ranges shown using "to" indicate ranges including the numerical values described before and after "to" as a lower limit value and an upper limit value.

Further, in a case where substitution or unsubstitution is not noted in regard to the notation of a "group" (atomic group) in the present specification, the "group" includes not only a group that does not have a substituent but also a group having a substituent. For example, the concept of an "alkyl group" includes not only an alkyl group that does not have a substituent (unsubstituted alkyl group) but also an alkyl group having a substituent (substituted alkyl group).

In the present specification, the concept of "(meth)acryl" includes both of acryl and methacryl, and the concept of"(meth)acryloyl" includes both of acryloyl and methacryloyl.

Further, the term "step" in the present specification indicates not only an independent step but also a step which cannot be clearly distinguished from other steps as long as the intended purpose of the step is achieved. Further, in the present disclosure, "% by mass" has the same definition as that for "% by weight", and "part by mass" has the same definition as that for "part by weight".

Further, in the present disclosure, a combination of two or more preferable aspects is a more preferable aspect.

Further, the weight-average molecular weight (Mw) and the number-average molecular weight (Mn) in the present disclosure are molecular weights in terms of polystyrene used as a standard substance, which are detected by using a solvent tetrahydrofuran (THF), a differential refractometer, and a gel permeation chromatography (GPC) analyzer using TSKgel GMHxL, TSKgel G4000HxL, and TSKgel G2000HxL (all trade names, manufactured by Tosoh Corporation) as columns, unless otherwise specified.

In the present specification, the term "lithographic printing plate precursor" includes not only a lithographic printing plate precursor but also a key plate precursor. Further, the term "lithographic printing plate" includes not only a lithographic printing plate produced by performing operations such as exposure and development, on a lithographic printing plate precursor as necessary but also a key plate. In a case of the key plate precursor, operations of exposure and development are not necessarily required. Further, a key plate is a lithographic printing plate precursor for attachment to a plate cylinder that is not used, for example, in a case where printing is performed on a part of a paper surface with one or two colors in color newspaper printing.

Hereinafter, the present disclosure will be described in detail.

### (Lithographic printing plate precursor)

A lithographic printing plate precursor according to the embodiment of the present disclosure includes a support, an image recording layer, and an overcoat layer in this order, in which the overcoat layer includes a water-soluble polymer and particles, the melting point of the particles is in a range of 70°C to 150°C, and a volume average particle diameter of the particles is greater than 0.7 µm.

The lithographic printing plate precursor according to the embodiment of the present disclosure is an on-press development type lithographic printing plate precursor.

As the result of intensive research conducted by the present inventors, it was found that a lithographic printing plate precursor which has excellent scratch resistance and developability can be provided by employing the above-described configuration.

The mechanism of the excellent effects obtained by employing the above-described configuration is not clear, but is assumed as follows.

As described above, the present inventors found that at least one of the scratch resistance or the developability in a lithographic printing plate precursor of the related art is not sufficient, which is problematic.

As the result of intensive research conducted by the present inventors, it was found that, the lithographic printing plate precursor has the overcoat layer including the particles having a melting point in a range of 70°C to 150°C, whereby, for example, even in a case of laminating the lithographic printing plate precursor, projections decrease the contact area, and friction attributed to scratches softens the particles, and thus scratched portions slip, whereby a significant contribution is made to reduction of scratch damages, and scratch resistance is excellent. In addition, it was found by the present inventor that the overcoat layer further includes the water-soluble polymer, whereby not only the scratch resistance is excellent, but developability is also excellent.

In addition, in the lithographic printing plate precursor according to the embodiment of the present disclosure, the water-soluble polymer and the particles are used in combination in the overcoat layer, whereby an on-press development scum-suppressing property is also excellent.

### <Overcoat layer>

The lithographic printing plate precursor according to the embodiment of the present disclosure includes the overcoat layer which includes a water-soluble polymer and particles, the melting point of the particles is in a range of 70°C to 150°C, a volume average particle diameter of the particles is greater than 0.7 µm.

From the viewpoint of the scratch resistance, the developability, and the on-press development scum-suppressing property, an outermost layer on the image recording layer side in the lithographic printing plate precursor is preferably the overcoat layer, more preferably an overcoat layer including 90% by mass or more of the particles and the water-soluble polymer, and particularly preferably an overcoat layer formed of the particles and the water-soluble polymer.

In addition, the overcoat layer may be a single layer or two or more layers; however, from the viewpoint of the scratch resistance, the developability, and the on-press development scum-suppressing property, a surface of the outermost layer on the image recording layer side in the lithographic printing plate precursor is preferably formed of the particles and the water-soluble polymer.

Further, from the viewpoint of the scratch resistance, the developability, and the on-press development scum-suppressing property, the area ratio (occupation area ratio) occupied by the particles in the surface of the outermost layer on the image recording layer side in the lithographic printing plate precursor is preferably 40% or less, more preferably 20% or less, still more preferably 0.1% or more and 15% or less, and particularly preferably 1% or more and 10% or less.

The occupation area ratio of the particles in the surface of the outermost layer in the present disclosure is measured using the following method.

After a carbon or Pt-Pd film is applied to a sample as a conductive treatment such that the thickness thereof is set to 3 nm, a reflection electron image is observed at an acceleration voltage of 5 kV to 10 kV using a SU8010 type FE-SEM (manufactured by Hitachi High-Technologies Corporation). The occupation area ratio of the particles is calculated by performing a binarization processing on an image captured by setting the observation magnification of 1,000 times and N = 3 using a difference in contrast between the particles and the surrounding area thereof with image processing software (ImageJ or the like).

From the viewpoint of the scratch resistance, the developability, and the on-press development scum-suppressing property, the overcoat layer preferably contains 50 particles/mm² or greater of the particles having a particle diameter of greater than 0.7 µm, more preferably contains 120 particles/mm² or greater and 5,000 particles/mm² or less, and particularly preferably contains 150 particles/mm² or greater and 3,000 particles/mm² or less. The overcoat layer more preferably contains 10,000 particles/mm² or greater of the particles having a particle diameter of greater than 0.7 µm.

In a method of measuring the number of the particles per unit area (mm²) of the overcoat layer in the present disclosure, a 100 µm² surface is observed using a secondary electron detector of a scanning electron microscope (SEM), and the number of the particles is measured and multiplied by 100.

From the viewpoint of the scratch resistance, the developability, and the on-press development scum-suppressing property, the average film thickness of a portion free from the particles in the overcoat layer is preferably smaller than the volume average particle diameter of the particles.

In addition, from the viewpoint of the scratch resistance, the developability, and the on-press development scum-suppressing property, the average film thickness of the overcoat layer is preferably smaller than the volume average particle diameter of the particles.

From the viewpoint of the scratch resistance, the developability, and the on-press development scum-suppressing property, the value of the volume average particle diameter of the particles/the average film thickness of the portion free from the particles in the overcoat layer is preferably 1 or greater, more preferably 10 or greater, still more preferably 10 or greater and 3,000 or less, particularly preferably 100 or greater and 2,000 or less, and most preferably 200 or greater and 800 or less.

The volume average particle diameter of the particles is greater than 0.7 µm, from the viewpoint of the scratch resistance, the developability, and the on-press development scum-suppressing property, preferably 0.75 µm or greater and 50 µm or less, more preferably 5 µm or greater and 50 µm or less, and particularly preferably 9 µm or greater and 50 µm or less.

In the present disclosure, the volume average particle diameter of the particles is calculated according to a laser light scattering method.

From the viewpoint of the scratch resistance, the developability, and the on-press development scum-suppressing property, the average film thickness of the portion free from the particles in the overcoat layer is preferably 0.001 µm or greater and 5 µm or less, more preferably 0.005 µm or greater and 2 µm or less, still more preferably 0.01 µm or greater and 0.5 µm or less, and particularly preferably 0.02 µm or greater and 0.2 µm or less.

Further, from the viewpoint of the scratch resistance, the developability, and the on-press development scum-suppressing property, the portion free from the particles in the overcoat layer is preferably a portion formed of the water-soluble polymer in the overcoat layer.

In a method of measuring the average film thickness of the portion free from the particles in the overcoat layer, the film thickness of the portion free from the particles in the overcoat layer is measured at five places in cross-sectional observation, and the average value is calculated.

The melting point of the particles is in a range of 70°C to 150°C, from the viewpoint of the scratch resistance, the developability, and the on-press development scum-suppressing property, preferably in a range of 80°C to 145°C, and more preferably in a range of 90°C to 140°C. In a case where the melting point of the particles is in a range of 70°C to 150°C, the projections are melted due to heat generated from friction caused by scratching, the scratched portion slips because of the melting so that the shearing stress is dispersed, and thus the scratch resistance of the outer layer becomes excellent. In a case where the melting point of the projections is in a range of 70°C to 150°C, since the projections become soft, the impressing property is not almost affected.

The method of measuring the melting point of the particles in the present disclosure is measured according to the following method.

The melting point thereof is measured by collecting particles using a differential scanning calorimetry (DSC) device (Q2000) (manufactured by TA Instruments, Inc.) in a temperature range of -30°C to 170°C at a temperature increase rate of 10 mm/min using an aluminum pan.

The particles are not particularly limited as long as the melting point is in a range of 70°C to 150°C; however, from the viewpoint of the scratch resistance, the developability, and the on-press development scum-suppressing property, organic resin particles are preferable, at least one kind of particles selected from the group consisting of polyethylene particles and modified polyethylene particles are more preferable, and high-density or low-density polyethylene particles are particularly preferable.

Further, from the viewpoint of the scratch resistance, the developability, and the on-press development scum-suppressing property, the particles are preferably organic wax particles.

Suitable examples of the organic wax particles include AQUAMAT 263, AQUAMAT 272, and AQUACER 537 which are commercially available from BYK.

Further, as the particles, particles having fluorinated or non-fluorinated hydrocarbon including fluorinated or non-fluorinated polyolefins such as fluorinated or non-fluorinated hydrocarbon containing low-density polyethylene, high-density polyethylene, polypropylene, polytetrafluoroethylene, or a mixture thereof are also preferable.

The overcoat layer includes a water-soluble polymer.

The water-soluble polymer in the present disclosure is a polymer compound that dissolves as much as 1 g or more in 100 g of water at 25°C, preferably a polymer compound that dissolves as much as 5 g or more in 100 g of water at 25°C, and more preferably a polymer compound that dissolves as much as 10 g or more in 100 g of water at 25°C.

Further, in the present disclosure, the polymer refers to a compound having a weight-average molecular weight of 1,000 or greater.

From the viewpoint of the scratch resistance, the developability, and the on-press development scum-suppressing property, a Clog P value of the water-soluble polymer is preferably -3 to 1, more preferably -0.6 to 0.8, and particularly preferably -0.6 to 0.4.

The Clog P value is a value of the common logarithm log P of a partition coefficient P to 1-octanol and water obtained by calculation. As a method or software used for the calculation of the Clog P value, well-known method or software can be used; however, in the present disclosure, unless otherwise described, a Clog P program combined into ChemBioDraw Ultra 12.0 by Cambridge Soft Corporation is used.

The water-soluble polymer preferably has at least one selected from the group consisting of a structure including a hydroxy group, a structure including a pyrrolidone ring, and a structure including an oxyalkylene group, which have an affinity particularly to water, as a repeating unit and more preferably has a structure including an oxyalkylene group as a structural repeating unit.

Specific examples of the water-soluble polymer including a hydroxy group include gum arabic, soya gum, carboxymethyl cellulose, hydroxymethyl cellulose, hydroxyethyl cellulose, polyhydroxyethylated cellulose, hydroxypropyl cellulose, hydroxypropylmethyl cellulose, glyoxalized hydroxypropylmethyl cellulose, hydroxypropylmethyl cellulose phthalate, methyl cellulose, and polyvinyl alcohol.

Specific examples of the water-soluble polymer including a pyrrolidone ring include polyvinyl pyrrolidone and a copolymer of vinyl pyrrolidone and vinyl acetate.

As specific examples of the water-soluble polymer including an oxyalkylene group, polyalkylene glycols such as polyethylene glycol and polyoxyethylene polyoxypropylene glycol (also referred to as polyoxyethylene-polyoxypropylene condensate), polyoxyalkylene monoalkyl or aryl ethers such as poly(ethylene glycol) methyl ether or poly(ethylene glycol) phenyl ether, polyglycerins or esters of the polyglycerins such as polyoxyethylene polyoxypropylene alkyl ether, polyglycerin, polyoxyethylene glycerin, and polyoxyethylene polyoxypropylene glyceryl ether, polyoxyethylene monoester, and polyoxyethylene alkyl ether ester are suitably used.

Among them, the water-soluble polymer preferably includes a polysaccharide, and from the viewpoint of the scratch resistance, the developability, and the on-press development scum-suppressing property, the water-soluble polymer more preferably includes a cellulose compound.

The polysaccharide is not particularly limited as long as the polysaccharide is water-soluble, and examples of the polysaccharide include polysaccharides, polysaccharide derivatives, and alkali metal salts of these.

The cellulose compound in the present disclosure is a compound having water solubility, and preferably a compound in which a part of cellulose is modified.

As the cellulose compound, a compound in which at least a part of a hydroxyl group in cellulose is substituted with at least one selected from the group consisting of an alkyl group or a hydroxyalkyl group is preferably exemplified.

As the cellulose compound, alkyl cellulose compound or hydroxyalkyl cellulose compound is preferable, alkyl cellulose compound is more preferable, and methyl cellulose is particularly preferable.

As the hydroxyalkyl cellulose compound, hydroxypropyl cellulose or methyl cellulose is preferably exemplified.

As the water-soluble polymer, from the viewpoint of the scratch resistance, the developability, and the on-press development scum-suppressing property, at least one water-soluble polymer selected from the group consisting of a cellulose compound, polyvinyl alcohol (PVA), polyvinyl pyrrolidone (PVP), and polyethylene glycol (PEG) is preferable, at least one water-soluble polymer selected from the group consisting of PVA, PVP, and methyl cellulose is more preferable, and methyl cellulose is particularly preferable.

The weight-average molecular weight (Mw) of the water-soluble polymer which is used in the present disclosure can be arbitrarily set by the performance design of the lithographic printing plate precursor.

Here, from the viewpoint of the scratch resistance, the developability, and the on-press development scum-suppressing property, the weight-average molecular weight (Mw) of the water-soluble polymer is preferably 1,000 to 200,000, more preferably 3,000 to 100,000, and particularly preferably 5,000 to 70,000. In a case where the weight-average molecular weight is in the above-described range, the developability and the scratch resistance are excellent. The weight-average molecular weight (Mw) of the water-soluble polymer compound can be measured by the gel permeation chromatography (GPC) method in which polyethylene glycol is used as a standard substance.

The overcoat layer may singly contain one kind of particle or may contain two or more kinds of particles.

Further, the overcoat layer may singly contain one water-soluble polymer or may contain two or more water-soluble polymers.

From the viewpoint of the scratch resistance, the developability, and the on-press development scum-suppressing property, the total content of the particles and the water-soluble polymer in the overcoat layer is preferably 50% by mass or more, more preferably 80% by mass or more, still more preferably 90% by mass or more, particularly preferably 95% by mass or more, and most preferably 99% by mass or more.

From the viewpoint of the scratch resistance, the developability, and the on-press development scum-suppressing property, the mass ratio (particles:water-soluble polymer) of the content of the particles to the content of the water-soluble polymer in the overcoat layer is preferably 20:1 to 1:20, more preferably 20:1 to 1:10, still more preferably 10:1 to 1:5, and particularly preferably 2:1 to 1:2.

Further, from the viewpoint of the scratch resistance, the developability, and the on-press development scum-suppressing property, the content of the particles in the overcoat layer is preferably 10% by mass or more and 95% by mass or less, more preferably 30% by mass or more and 95% by mass or less, and particularly preferably 40% by mass or more and 70% by mass or less with respect to the total mass of the overcoat layer.

Further, from the viewpoint of the scratch resistance, the developability, and the on-press development scum-suppressing property, the content of the water-soluble polymer in the overcoat layer is preferably 5% by mass or more and 90% by mass or less, more preferably 5% by mass or more and 70% by mass or less, and particularly preferably 30% by mass or more and 60% by mass or less with respect to the total mass of the overcoat layer.

### <Support>

The lithographic printing plate precursor according to the embodiment of the present disclosure has a support.

As the support used in the lithographic printing plate precursor according to the embodiment of the present disclosure, a known support is used.

Further, as the support used in the lithographic printing plate precursor according to the embodiment of the present disclosure, an aluminum support is preferable, and a hydrophilized aluminum support is more preferable.

Among these, an aluminum plate which has been subjected to an anodizing treatment is more preferable and an aluminum plate which has been subjected to a roughening treatment and an anodizing treatment is particularly preferable.

The roughening treatment and the anodizing treatment can be performed according to known methods.

The aluminum plate can be subjected to a treatment appropriately selected from an expansion treatment or a sealing treatment of micropores of an anodized film described in JP2001-253181A or JP2001-322365A or a surface hydrophilization treatment using alkali metal silicate described in US2714066A, US3181461A, US3280734A, and US3902734A or polyvinyl phosphonic acid described in US3276868A, US4153461A, and US4689272A as necessary.

The center line average roughness Ra of the support is preferably in a range of 0.10 µm to 1.2 µm.

The rear surface of the support may be provided with an organic polymer compound described in JP1993-045885A (JP-H05-045885A) and a back coat layer including an alkoxy compound of silicon described in JP1994-035174A(JP-H06-035174A) as necessary.

### <Image recording layer>

The lithographic printing plate precursor according to the embodiment of the present disclosure has an image recording layer on the support.

The image recording layer in the present disclosure may be a positive type image recording layer or a negative type image recording layer, but a negative type image recording layer is preferable.

Further, it is preferable that the image recording layer in the present disclosure is an image recording layer according to any of the following first and third to fifth aspects.

First aspect: The image recording layer contains an infrared absorbent, a polymerizable compound, and a polymerization initiator.

Second aspect (not according to the invention): The image recording layer contains an infrared absorbent and thermoplastic polymer particles.

Third aspect: In the first aspect, the image recording layer further contains polymer particles or a microgel.

Fourth aspect: In the first aspect, the image recording layer further contains thermoplastic polymer particles.

Fifth aspect: In the fourth aspect, the image recording layer further contains a microgel.

According to the first aspect, it is possible to obtain a lithographic printing plate precursor from which a lithographic printing plate having excellent printing durability is obtained.

According to the third aspect, it is possible to obtain a lithographic printing plate precursor having excellent on-press developability.

According to the fourth aspect, it is possible to obtain a lithographic printing plate precursor having further excellent printing durability.

According to the fifth aspect, it is possible to obtain a lithographic printing plate precursor having further excellent printing durability.

Further, as the positive type image recording layer, a known image recording layer can be used.

According to a preferable aspect of the lithographic printing plate precursor according to the embodiment of the present disclosure, the image recording layer is an image recording layer (hereinafter, also referred to as an "image recording layer A") containing an infrared absorbent, a polymerization initiator, a polymerizable compound, and a binder polymer.

According to another preferable aspect of the lithographic printing plate precursor according to the embodiment of the present disclosure, the image recording layer is an image recording layer (hereinafter, also referred to as an "image recording layer B") containing an infrared absorbent, a polymerization initiator, a polymerizable compound, and a polymer compound having a particle shape.

### -Image recording layer A-

The image recording layer A contains an infrared absorbent, a polymerization initiator, a polymerizable compound, and a binder polymer. Hereinafter, the constituent components of the image recording layer A will be described.

### <<Infrared absorbent>>

An infrared absorbent has a function of converting absorbed infrared rays into heat and a function of transferring electrons or energy or transferring both electrons and energy to a polymerization initiator described below through excitation by infrared rays. As the infrared absorbent used in the present disclosure, a dye or a pigment having maximum absorption at a wavelength of 760 nm to 1,200 nm is preferable and the dye is more preferable.

As the dye, dyes described in paragraphs 0082 to 0088 of JP2014-104631A can be used.

The average particle diameter of the pigment is preferably in a range of 0.01 µm to 1 µm and more preferably in a range of 0.01 µm to 0.5 µm. A known dispersion technique used to produce inks or toners can be used for dispersion of the pigment. The details are described in "Latest Pigment Application Technology" (CMC Publishing Co., Ltd., published in 1986) and the like.

The infrared absorbent may be used alone or in combination of two or more kinds thereof.

The content of the infrared absorbent is preferably in a range of 0.05% by mass to 30% by mass, more preferably in a range of 0.1% by mass to 20% by mass, and particularly preferably in a range of 0.2% by mass to 10% by mass with respect to the total mass of the image recording layer.

### «Polymerization initiator»

The polymerization initiator indicates a compound that initiates and promotes polymerization of a polymerizable compound. As the polymerization initiator, a known thermal polymerization initiator, a compound having a bond with small bond dissociation energy, or a photopolymerization initiator can be used. Specifically, radical polymerization initiators described in paragraphs 0092 to 0106 of JP2014-10463 1A can be used.

Preferred examples of compounds in the polymerization initiators include onium salts. Among these, iodonium salts and sulfonium salts are particularly preferable. Preferred specific examples of the compounds in each of the salts are compounds described in paragraphs 0104 to 0106 of JP2014-10463 1A.

The content of the polymerization initiator is preferably in a range of 0.1% to 50% by mass, more preferably in a range of 0.5% to 30% by mass, and particularly preferably in a range of 0.8% to 20% by mass with respect to the total mass of the image recording layer. In a case where the content thereof is in the above-described range, improved sensitivity and improved stain resistance of a non-image area at the time of printing are obtained.

### «Polymerizable compound»

A polymerizable compound is an addition polymerizable compound having at least one ethylenically unsaturated bond, and is preferably selected from compounds having at least one, more preferably two or more, terminal ethylenically unsaturated bonds. These have chemical forms such as a monomer, a pre-polymer, that is, a dimer, a trimer, and an oligomer, and a mixture of these. Specifically, polymerizable compounds described in paragraphs 0109 to 0113 of JP2014-10463 1A can be used.

Among the examples described above, from the viewpoint that the balance between hydrophilicity associated with on-press developability and polymerization ability associated with printing durability is excellent, isocyanuric acid ethylene oxide-modified acrylates such as tris(acryloyloxyethyl) isocyanurate and bis(acryloyloxyethyl)hydroxyethyl isocyanurate are particularly preferable.

The details of the structures of these polymerizable compounds, whether to be used alone or in combination, and the usage method such as the addition amount can be arbitrarily set according to the final performance design of a lithographic printing plate precursor. The content of the above-described polymerizable compound to be used is preferably in a range of 5% by mass to 75% by mass, more preferably in a range of 10% by mass to 70% by mass, and particularly preferably in a range of 15% by mass to 60% by mass with respect to the total mass of the image recording layer.

### <Binder polymer>

A binder polymer can be mainly used to improve the film hardness of the image recording layer. As the binder polymer, known binder polymers of the related art can be used and polymers having coated-film properties are preferable. Among examples thereof, an acrylic resin, a polyvinyl acetal resin, and a polyurethane resin are preferable.

Suitable examples of the binder polymer include polymers having a cross-linking functional group in the main chain or side chain, preferably in the side chain, for improving coated-film hardness of an image area as described in JP2008-195018A. Cross-linking occurs between polymer molecules by a cross-linking group so that curing is promoted.

Preferred examples of the cross-linking functional group include an ethylenically unsaturated group such as a (meth)acryl group, a vinyl group, an allyl group, or a styryl group (vinyl group bonded to a benzene ring) and an epoxy group, and the cross-linking functional group can be introduced into a polymer by a polymer reaction or copolymerization. For example, a reaction between an acrylic polymer having a carboxy group in the side chain thereof or polyurethane and glycidyl methacrylate or a reaction between a polymer having an epoxy group and ethylenically unsaturated group-containing carboxylic acid such as methacrylic acid can be used.

The content of the cross-linking group in the binder polymer is preferably in a range of 0.1 mmol to 10.0 mmol, more preferably in a range of 0.25 mmol to 7.0 mmol, and particularly preferably in a range of 0.5 mmol to 5.5 mmol per 1 g of the binder polymer.

Moreover, it is preferable that the binder polymer includes a hydrophilic group. The hydrophilic group contributes to imparting on-press developability to the image recording layer. Particularly, in the coexistence of a cross-linking group and a hydrophilic group, both of printing durability and on-press developability can be achieved.

Examples of the hydrophilic group include a hydroxy group, a carboxy group, an alkylene oxide structure, an amino group, an ammonium group, an amide group, a sulfo group, and a phosphoric acid group. Among these, an alkylene oxide structure having 1 to 9 alkylene oxide units having 2 or 3 carbon atoms is preferable. A monomer having a hydrophilic group may be copolymerized in order to impart a hydrophilic group to a binder polymer.

In addition, in order to control the impressing property, a lipophilic group such as an alkyl group, an aryl group, an aralkyl group, or an alkenyl group can be introduced into the binder polymer. For example, a lipophilic group-containing monomer such as methacrylic acid alkyl ester may be copolymerized.

The weight-average molecular weight (Mw) of the binder polymer is preferably 2,000 or greater, more preferably 5,000 or greater, and still more preferably in a range of 10,000 to 300,000.

The content of the binder polymer is preferably in a range of 3% by mass to 90% by mass, more preferably in a range of 5% by mass to 80% by mass, and still more preferably in a range of 10% by mass to 70% by mass with respect to the total mass of the image recording layer.

As a preferred example of the binder polymer, a polymer compound having a polyoxyalkylene chain in the side chain is exemplified. In a case where the image recording layer contains a polymer compound having a polyoxyalkylene chain in the side chain (hereinafter, also referred to as a "POA chain-containing polymer compound"), permeability of dampening water is promoted and on-press developability is improved.

Examples of the resin constituting the main chain of the POA chain-containing polymer compound include an acrylic resin, a polyvinyl acetal resin, a polyurethane resin, a polyurea resin, a polyimide resin, a polyamide resin, an epoxy resin, a methacrylic resin, a polystyrene-based resin, a novolac type phenolic resin, a polyester resin, synthetic rubber, and natural rubber. Among these, an acrylic resin is particularly preferable.

Further, in the present disclosure, a "main chain" indicates relatively the longest bonding chain in a molecule of a polymer compound constituting a resin and a "side chain" indicates a branched chain branched from the main chain.

The POA chain-containing polymer compound does not substantially contain a perfluoroalkyl group. The expression "does not substantially contain a perfluoroalkyl group" means that the mass ratio of a fluorine atom present as a perfluoroalkyl group in a polymer compound is less than 0.5% by mass, and it is preferable that the polymer compound does not contain a fluorine atom. The mass ratio of the fluorine atom is measured by an elemental analysis method.

In addition, the "perfluoroalkyl group" is a group in which all hydrogen atoms of the alkyl group are substituted with fluorine atoms.

As alkyleneoxide (oxyalkylene) in a polyoxyalkylene chain, alkyleneoxide having 2 to 6 carbon atoms (also referred to as "number of carbon atoms") is preferable, ethyleneoxide (oxyethylene) or propyleneoxide (oxypropylene) is more preferable, and ethyleneoxide is still more preferable.

The repetition number of the alkyleneoxide in a polyoxyalkylene chain, that is, a polyalkyleneoxide moiety is preferably in a range of 2 to 50 and more preferably in a range of 4 to 25.

In a case where the repetition number of the alkyleneoxide is 2 or greater, the permeability of dampening water is sufficiently improved. Further, from the viewpoint that a degradation of printing durability is suppressed due to abrasion, it is preferable that the repetition number thereof is 50 or less.

As the polyalkyleneoxide moiety, structures described in paragraphs 0060 to 0062 of JP2014-104631Aare preferable.

The POA chain-containing polymer compound may have cross-linking properties in order to improve coated-film hardness of an image area. Examples of the POA chain-containing polymer compounds having cross-linking properties are described in paragraphs 0063 to 0072 of JP2014-10463 1A.

The proportion of repeating units having a polyalkyleneoxide moiety in the total repeating units constituting the POA chain-containing polymer compound is not particularly limited, but is preferably in a range of 0.5 mol% to 80 mol% and more preferably in a range of 0.5 mol% to 50 mol%. Specific examples of the POA chain-containing polymer compounds are described in paragraphs 0075 and 0076 of JP2014-104631A.

As the POA chain-containing polymer compound, hydrophilic polymer compounds such as polyacrylic acid and polyvinyl alcohol described in JP2008-195018A can be used in combination as necessary. Further, a lipophilic polymer compound and a hydrophilic polymer compound can be used in combination.

In addition to the presence of the POA chain-containing polymer compound in the image recording layer as a binder that plays a role of connecting image recording layer components with each other, the specific polymer compound may be present in the form of particles. In a case where the specific polymer compound is present in the form of particles, the average particle diameter is in a range of 10 nm to 1,000 nm, preferably in a range of 20 nm to 300 nm, and particularly preferably in a range of 30 nm to 120 nm.

The content of the POA chain-containing polymer compound is preferably in a range of 3% by mass to 90% by mass and more preferably in a range of 5% by mass to 80% by mass with respect to the total mass of the image recording layer. In a case where the content thereof is in the above-described range, both of permeability of dampening water and image formability can be reliably achieved.

Other preferred examples of the binder polymer include a polymer compound (hereinafter, also referred to as a "star type polymer compound") which has a polymer chain bonded to a nucleus through a sulfide bond by means of using a polyfunctional, in a range of hexa- to deca-functional, thiol as the nucleus and in which the polymer chain has a polymerizable group. As the star type polymer compound, for example, compounds described in JP2012-148555A can be preferably used.

Examples of the star type polymer compound include compounds having a polymerizable group such as an ethylenically unsaturated bond in the main chain or in the side chain, preferably in the side chain, for improving coated-film hardness of an image area as described in JP2008-195018A. Cross-linking occurs between polymer molecules by a polymerizable group so that curing is promoted.

Preferred examples of the polymerizable group include an ethylenically unsaturated group such as a (meth)acryl group, a vinyl group, an allyl group, or a styryl group and an epoxy group. Among these, from the viewpoint of polymerization reactivity, a (meth)acryl group, a vinyl group, or a styryl group is more preferable and a (meth)acryl group is particularly preferable. These groups can be introduced into a polymer by a polymer reaction or copolymerization. For example, a reaction between a polymer having a carboxy group in the side chain thereof and glycidyl methacrylate or a reaction between a polymer having an epoxy group and ethylenically unsaturated group-containing carboxylic acid such as methacrylic acid can be used. These groups may be used in combination.

The content of the cross-linking group in the star type polymer compound is preferably in a range of 0.1 mmol to 10.0 mmol, more preferably in a range of 0.25 mmol to 7.0 mmol, and particularly preferably in a range of 0.5 mmol to 5.5 mmol per 1 g of the star type polymer compound.

Moreover, it is preferable that the star type polymer compound further includes a hydrophilic group. The hydrophilic group contributes to imparting on-press developability to the image recording layer. Particularly, in the coexistence of a polymerizable group and a hydrophilic group, both of printing durability and on-press developability can be achieved.

Examples of the hydrophilic group include -SO₃M¹, -OH, -CONR¹R² (M¹ represents a hydrogen atom, a metal ion, an ammonium ion, or a phosphonium ion, R¹ and R² each independently represent a hydrogen atom, an alkyl group, an alkenyl group, or an aryl group, and R¹ and R² may be bonded to each other to form a ring), -N⁺R³R⁴R⁵X⁻ (R³ to R⁵ each independently represent an alkyl group having 1 to 8 carbon atoms and X⁻ represents a counter anion), -(CH₂CH₂O)ₙR, and -(C₃H₆O)ₘR.

In the above-described formulae, n and m each independently represent an integer of 1 to 100 and R's each independently represent a hydrogen atom or an alkyl group having 1 to 18 carbon atoms.

Here, in a case where the star type polymer compound is a star type polymer compound having a polyoxyalkylene chain (for example, -(CH₂CH₂O)ₙR and -(C₃H₆O)ₘR) in the side chain, such a star type polymer compound is a polymer compound having the above-described polyoxyalkylene chain in the side chain.

Among these hydrophilic groups, -CONR¹R², -(CH₂CH₂O)ₙR, or -(C₃H₆O)ₘR is preferable, -CONR¹R² or -(CH₂CH₂O)ₙR is more preferable, and -(CH₂CH₂O)ₙR is particularly preferable. In -(CH₂CH₂O)ₙR, n represents preferably 1 to 10 and particularly preferably 1 to 4. Further, R represents more preferably a hydrogen atom or an alkyl group having 1 to 4 carbon atoms and particularly preferably a hydrogen atom or a methyl group. These hydrophilic groups may be used in combination of two or more kinds thereof.

Further, it is preferable that the star type polymer compound does not substantially include a carboxylic acid group, a phosphoric acid group, or a phosphonic acid group. Specifically, the amount of these acid groups is preferably less than 0.1 mmol/g, more preferably less than 0.05 mmol/g, and particularly preferably 0.03 mmol/g or less. In a case where the amount of these acid groups is less than 0.1 mmol/g, on-press developability is further improved.

In order to control the impressing property, a lipophilic group such as an alkyl group, an aryl group, an aralkyl group, or an alkenyl group can be introduced into the star type polymer compound. Specifically, a lipophilic group-containing monomer such as methacrylic acid alkyl ester may be copolymerized.

Specific examples of the star type polymer compound include compounds described in paragraphs 0153 to 0157 of JP2014-104631A.

The star type polymer compound can be synthesized, using a known method, by performing radical polymerization on the above-described monomers constituting a polymer chain in the presence of the above-described polyfunctional thiol compound.

The weight-average molecular weight of the star type polymer compound is preferably in a range of 5,000 to 500,000, more preferably in a range of 10,000 to 250,000, and particularly preferably in a range of 20,000 to 150,000. In a case where the weight-average molecular weight thereof is in the above-described range, the on-press developability and the printing durability are more improved.

The star type polymer compound may be used alone or in combination of two or more kinds thereof. Further, the star type polymer compound may be used in combination with a typical linear binder polymer.

The content of the star type polymer compound is preferably in a range of 5% by mass to 95% by mass, more preferably in a range of 10% by mass to 90% by mass, and particularly preferably in a range of 15 to 85% by mass with respect to the total mass of the image recording layer.

From the viewpoint of promoting the permeability of dampening water and improving the on-press developability, star type polymer compounds described in JP2012-148555A are particularly preferable.

### <<Other components>>

The image recording layer A can contain other components described below as necessary.

### (1) Low-molecular weight hydrophilic compound

In order to improve the on-press developability without degrading the printing durability, the image recording layer may contain a low-molecular weight hydrophilic compound.

As the low-molecular weight hydrophilic compound, examples of a water-soluble organic compound include glycols such as ethylene glycol, diethylene glycol, triethylene glycol, propylene glycol, dipropylene glycol, and tripropylene glycol and ether or ester derivatives thereof; polyols such as glycerin, pentaerythritol, and tris(2-hydroxyethyl) isocyanurate; organic amines such as triethanolamine, diethanolamine, and monoethanolamine and salts thereof; organic sulfonic acids such as alkylsulfonic acid, toluenesulfonic acid, and benzenesulfonic acid and salts thereof; organic sulfamic acids such as alkyl sulfamic acid and salts thereof; organic sulfuric acids such as alkyl sulfuric acid and alkyl ether sulfuric acid and salts thereof; organic phosphonic acids such as phenyl phosphonic acid and salts thereof; organic carboxylic acids such as tartaric acid, oxalic acid, citric acid, malic acid, lactic acid, gluconic acid, and amino acids and salts thereof; and betaines.

Among these, it is preferable that the image recording layer contains at least one compound selected from the group consisting of polyols, organic sulfates, organic sulfonates, and betaines.

Specific examples of the compounds of the organic sulfonates include compounds described in paragraphs 0026 to 0031 of JP2007-276454A and paragraphs 0020 to 0047 of JP2009-154525A. The salt may be potassium salts or lithium salts.

Examples of the organic sulfates include compounds described in paragraphs 0034 to 0038 of JP2007-276454A.

As betaines, compounds having 1 to 5 carbon atoms of hydrocarbon substituents to nitrogen atoms are preferable. Specific examples thereof include trimethyl ammonium acetate, dimethyl propyl ammonium acetate, 3-hydroxy-4-trimethyl ammonio butyrate, 4-(1-pyridinio)butyrate, 1-hydroxyethyl-1-imidazolioacetate, trimethyl ammonium methane sulfonate, dimethyl propyl ammonium methane sulfonate, 3-trimethylammonio-1-propane sulfonate, and 3-(1-pyridinio)-1-propane sulfonate.

Since the low-molecular weight hydrophilic compound has a small structure of a hydrophobic portion, hydrophobicity or coated-film hardness of an image area is not degraded by dampening water permeating into an image recording layer exposed area (image area) and ink receptivity or printing durability of the image recording layer can be maintained satisfactorily.

The addition amount of the low-molecular weight hydrophilic compound is preferably in a range of 0.5% by mass to 20% by mass, more preferably in a range of 1% by mass to 15% by mass, and still more preferably in a range of 2% by mass to 10% by mass with respect to the total mass of the image recording layer. In a case where the amount thereof is in the above-described range, excellent on-press developability and printing durability can be obtained.

The low-molecular weight hydrophilic compound may be used alone or in combination of two or more kinds thereof.

### (2) Oil sensitizing agent

In order to improve the impressing property, an oil sensitizing agent such as a phosphonium compound, a nitrogen-containing low-molecular weight compound, or an ammonium group-containing polymer can be used for the image recording layer. Particularly, in a case where a protective layer contains an inorganic layered compound, the above-described compounds function as a surface coating agent of the inorganic layered compound and prevent a degradation in impressing property due to the inorganic layered compound during the printing.

The phosphonium compound, the nitrogen-containing low-molecular weight compound, and the ammonium group-containing polymer are described in paragraphs 0184 to 0190 of JP2014-104631A in detail.

The content of the oil sensitizing agent is preferably in a range of 0.01% by mass to 30.0% by mass, more preferably in a range of 0.1% by mass to 15.0% by mass, and still more preferably in a range of 1% by mass to 10% by mass with respect to the total mass of the image recording layer.

### (3) Other components

The image recording layer may further contain other components such as a surfactant, a coloring agent, a printing-out agent, a polymerization inhibitor, a higher fatty acid derivative, a plasticizer, inorganic particles, an inorganic layered compound, a co-sensitizer, and a chain transfer agent. Specifically, the compounds and the addition amounts described in paragraphs 0114 to 0159 of JP2008-284817A, paragraphs 0023 to 0027 of JP2006-091479A, and paragraph 0060 of US2008/0311520A can be preferably used.

### <<Formation of image recording layer A»

The image recording layer A is formed by dispersing or dissolving each of the above-described required components in a known solvent to prepare a coating solution, coating a support with the coating solution directly or through an undercoat layer using a known method such as a bar coater coating method, and drying the resultant, as described in paragraphs 0142 and 0143 of JP2008-195018A. The coating amount of the image recording layer (solid content) on the support to be obtained after the coating and the drying varies depending on the applications thereof, but is preferably in a range of 0.3 g/m² to 3.0 g/m². In a case where the coating amount thereof is in the above-described range, excellent sensitivity and excellent film-coating characteristics of the image recording layer are obtained.

### -Image recording layer B-

The image recording layer B contains an infrared absorbent, a polymerization initiator, a polymerizable compound, and a polymer compound having a particle shape. Hereinafter, the constituent components of the image recording layer B will be described.

Similarly, the infrared absorbent, the polymerization initiator, and the polymerizable compound described in the image recording layer A can be used as an infrared absorbent, a polymerization initiator, and a polymerizable compound in the image recording layer B.

### «Polymer compound having particle shape»

It is preferable that the polymer compound having a particle shape is selected from the group consisting of thermoplastic polymer particles, thermally reactive polymer particles, polymer particles having a polymerizable group, a microcapsule encapsulating a hydrophobic compound, and a microgel (cross-linked polymer particles). Among these, polymer particles having a polymerizable group and a microgel are preferable. According to a particularly preferred embodiment, the polymer compound having a particle shape includes at least one ethylenically unsaturated polymerizable group. Because of the presence of the polymer compound having a particle shape, effects of improving the printing durability of an exposed area and the on-press developability of an unexposed area are obtained.

Further, it is preferable that the polymer compound having a particle shape is thermoplastic polymer particles.

Preferred examples of the thermoplastic polymer particles include thermoplastic polymer particles described in Research Disclosure No. 33303 on January, 1992, JP1997-123387A (JP-H09-123387A), JP1997-131850A (JP-H09-131850A), JP1997-171249A (JP-H09-171249A), JP1997-171250A(JP-H09-171250A), and EP931647B.

Specific examples of a polymer constituting the thermoplastic polymer particles include homopolymers or copolymers of monomers such as acrylate or methacrylate having structures of ethylene, styrene, vinyl chloride, methyl acrylate, ethyl acrylate, methyl methacrylate, ethyl methacrylate, vinylidene chloride, acrylonitrile, vinyl carbazole, and polyalkylene, and mixtures of these. Among these, polystyrene, a copolymer obtained by copolymerizing at least styrene and acrylonitrile, and polymethyl methacrylate are more preferable. The average particle diameter of the thermoplastic polymer particles is preferably in a range of 0.01 µm to 3.0 µm.

Examples of the thermally reactive polymer particles include polymer particles having a thermally reactive group. The thermally reactive polymer particles are cross-linked by a thermal reaction and have hydrophobic regions formed by a change in functional groups during the cross-linking.

As the thermally reactive group in polymer particles having a thermally reactive group, a functional group that performs any reaction may be used as long as a chemical bond is formed, but a polymerizable group is preferable. Preferred examples of the polymerizable group include an ethylenically unsaturated group that performs a radical polymerization reaction (such as an acryloyl group, a methacryloyl group, a vinyl group, or an allyl group); a cationic polymerizable group (such as a vinyl group, a vinyloxy group, an epoxy group, or an oxetanyl group); an isocyanate group that performs an addition reaction or a block body thereof, an epoxy group, a vinyloxy group, and a functional group having active hydrogen atom as a reaction partner of these (such as an amino group, a hydroxy group, or a carboxy group); a carboxy group that performs a condensation reaction and a hydroxy group or an amino group as a reaction partner thereof; and an acid anhydride that performs a ring-opening addition reaction and an amino group or a hydroxy group as a reaction partner thereof.

The microcapsule is a microcapsule in which at least a part of constituent components of the image recording layer is encapsulated as described in JP2001-277740A and JP2001-277742A. Further, the constituent components of the image recording layer may be contained in a portion other than the microcapsule. Moreover, a preferred embodiment of the image recording layer containing the microcapsule is an embodiment in which hydrophobic constituent components are encapsulated in a microcapsule and hydrophilic constituent components are contained in a portion other than the microcapsule.

The microgel (cross-linked polymer particles) may contain a part of the constituent components of the image recording layer in at least one of the surface or the inside of the microgel. From the viewpoints of image forming sensitivity and printing durability, a reactive microgel having a radical polymerizable group on the surface thereof is particularly preferable.

The constituent components of the image recording layer can be made into microcapsules or microgels using a known method.

From the viewpoints of the printing durability, stain resistance, and storage stability, it is preferable that the polymer compound having a particle shape is obtained by reacting a polyvalent isocyanate compound which is an addition product of a polyhydric phenol compound containing two or more hydroxy groups in a molecule and isophorone diisocyanate with a compound containing an active hydrogen.

As the polyhydric phenol compound, a compound having a plurality of benzene rings containing a phenolic hydroxy group is preferable.

As the compound containing an active hydrogen, a polyol compound or a polyamine compound is preferable, a polyol compound is more preferable, and at least one compound selected from the group consisting of propylene glycol, glycerin, and trimethylolpropane is still more preferable.

As the resin particles obtained by reacting the compound containing an active hydrogen with the polyvalent isocyanate compound which is an addition product of a polyhydric phenol compound containing two or more hydroxy groups in a molecule and isophorone diisocyanate, polymer particles described in paragraphs 0032 to 0095 of JP2012-206495A are preferably exemplified.

Further, from the viewpoints of the printing durability and the solvent resistance, it is preferable that the polymer compound having a particle shape has a hydrophobic main chain and both of a constitutional unit (i) which contains a pendant-cyano group directly bonded to the hydrophobic main chain and a constitutional unit (ii) which contains a pendant group having a hydrophilic polyalkylene oxide segment.

Preferred examples of the hydrophobic main chain include an acrylic resin chain.

Preferred examples of the pendant-cyano group include -[CH₂CH(C≡N)]- and -[CH₂C(CH₃)(C≡N)]-.

Further, a constitutional unit having the pendant-cyano group can be easily derived from an ethylene-based unsaturated monomer such as acrylonitrile or methacrylonitrile or a combination of these.

Further, as the alkylene oxide in the hydrophilic polyalkylene oxide segment, ethylene oxide or propylene oxide is preferable and ethylene oxide is more preferable.

The repetition number of alkylene oxide structures in the hydrophilic polyalkylene oxide segment is preferably in a range of 10 to 100, more preferably in a range of 25 to 75, and still more preferably in a range of 40 to 50.

As the resin particles which have a hydrophobic main chain and both of a constitutional unit (i) containing a pendant-cyano group directly bonded to the hydrophobic main chain and a constitutional unit (ii) containing a pendant group having a hydrophilic polyalkylene oxide segment, those described in paragraphs 0039 to 0068 of JP2008-503365A are preferably exemplified.

The average particle diameter of the polymer compound having a particle shape is preferably in a range of 0.01 µm to 3.0 µm, more preferably in a range of 0.03 µm to 2.0 µm, and still more preferably in a range of 0.10 µm to 1.0 µm. In a case where the average particle diameter thereof is in the above-described range, excellent resolution and temporal stability are obtained.

The content of the polymer compound having a particle shape is preferably in a range of 5% by mass to 90% by mass with respect to the total mass of the image recording layer.

### <<Other components>>

The image recording layer B can contain the other components described in the above-described image recording layer A as necessary.

### <Formation of image recording layer B>

The image recording layer B can be formed in the same manner as the image recording layer A described above.

Hereinafter, other constituent elements of the lithographic printing plate precursor will be described.

### <Undercoat layer>

The lithographic printing plate precursor according to the embodiment of the present disclosure may be provided with an undercoat layer between the image recording layer and the support as necessary. Since intimate attachment of the support to the image recording layer becomes stronger in an exposed area and the support is easily peeled off from the image recording layer in an unexposed area, the undercoat layer contributes to improvement of on-press developability without degrading printing durability. Further, in a case of infrared (IR) laser exposure, the undercoat layer functions as a heat insulating layer so that a degradation in sensitivity due to heat, generated by the exposure, being diffused in the support is prevented.

Examples of the compound used for the undercoat layer include a silane coupling agent having an ethylenic double bond reactive group, which is an addition-polymerizable group, described in JP1998-282679A (JP-H10-282679A); and a phosphorus compound having an ethylenic double bond reactive group described in JP1990-304441A (JP-H02-304441A). Preferred examples thereof include polymer compounds having an adsorptive group, which can be adsorbed to the surface of the support, a hydrophilic group, and a cross-linking group, as described in JP2005-125749A and JP2006-188038A. As such a polymer compound, a copolymer of a monomer having an adsorptive group, a monomer having a hydrophilic group, and a monomer having a cross-linking group is preferable. Specific examples thereof include a copolymer of a monomer having an adsorptive group such as a phenolic hydroxy group, a carboxy group, -PO₃H₂, -OPO₃H₂, -CONHSO₂-, -SO₂NHSO₂-, or -COCH₂COCH₃, a monomer having a hydrophilic group such as a sulfo group, and a monomer having a polymerizable cross-linking group such as a methacryl group or an allyl group. The polymer compound may have a cross-linking group introduced by forming salts between a polar substituent of the polymer compound and a compound that includes a substituent having the opposite charge of the polar substituent and an ethylenically unsaturated bond. Further, monomers other than the above-described monomers, preferably hydrophilic monomers may be further copolymerized.

The content of the ethylenically unsaturated bond in the polymer compound for an undercoat layer is preferably in a range of 0.1 to 10.0 mmol and more preferably in a range of 2.0 to 5.5 mmol per 1 g of the polymer compound.

The weight-average molecular weight of the polymer compound for an undercoat layer is preferably 5,000 or greater and more preferably in a range of 10,000 to 300,000.

For the purpose of preventing stain over time, the undercoat layer may contain a chelating agent, a secondary or tertiary amine, a polymerization inhibitor, a compound that includes an amino group or a functional group having polymerization inhibiting ability and a group interacting with the surface of an aluminum support, and the like (for example, 1,4-diazabicyclo[2.2.2]octane (DABCO), 2,3,5,6-tetrahydroxy-p-quinone, chloranil, sulfophthalic acid, hydroxyethyl ethylene diamine triacetic acid, dihydroxyethyl ethylene diamine diacetic acid, or hydroxyethyl imino diacetic acid) in addition to the compounds for an undercoat layer described above.

The undercoat layer is applied according to a known method. The coating amount of the undercoat layer in terms of a coating amount after drying is preferably in a range of 0.1 mg/m² to 100 mg/m² and more preferably in a range of 1 mg/m² to 30 mg/m².

The lithographic printing plate precursor can be produced by applying a coating solution of each configuration layer according to a typical method, performing drying, and forming each configuration layer. The coating solution can be applied according to a die coating method, a dip coating method, an air knife coating method, a curtain coating method, a roller coating method, a wire bar coating method, a gravure coating method, or a slide coating method.

Further, the overcoat layer is preferably formed of an aqueous coating solution including the particles and the water-soluble polymer.

### (Lithographic printing plate and production method thereof and lithographic printing method)

The lithographic printing plate according to the present disclosure is a lithographic printing plate obtained by plate-making the lithographic printing plate precursor according to the embodiment of the present disclosure.

The method of producing a lithographic printing plate according to the embodiment of the present disclosure is not particularly limited as long as the method is a method of producing a lithographic printing plate using the lithographic printing plate precursor according to the embodiment of the present disclosure, and it is preferable that the method is a production method of plate-making a lithographic printing plate using the lithographic printing plate precursor according to the embodiment of the present disclosure and includes a step of image-wise exposing the lithographic printing plate precursor according to the embodiment of the present disclosure to form an exposed area and an unexposed area (also referred to as an "image exposure step"); and a step of supplying at least one of printing ink or dampening water to remove a non-image area (also referred to as a "development treatment step").

The lithographic printing method according to the present disclosure is a method of producing a lithographic printing plate using the lithographic printing plate precursor according to the embodiment of the present disclosure and performing printing and is also a production method of plate-making a lithographic printing plate using the lithographic printing plate precursor according to the embodiment of the present disclosure, and it is preferable that the method includes a step of image-wise exposing the lithographic printing plate precursor according to the embodiment of the present disclosure to form an exposed area and an unexposed area (also referred to as an "image exposure step"); a step of supplying at least one of printing ink or dampening water to remove a non-image area (also referred to as a "development treatment step"); and a step of performing printing using the obtained lithographic printing plate (also referred to as a "printing step").

In the lithographic printing plate precursor according to the embodiment of the present disclosure, the development treatment step is performed without performing the image exposure step in a case of the key plate precursor.

### <Image exposure step>

The image exposure of the lithographic printing plate precursor can be performed in conformity with an image exposure operation for a typical lithographic printing plate precursor.

The image exposure is performed by laser exposure through a transparent original picture having a line image, a halftone image, and the like or by laser beam scanning using digital data. The wavelength of a light source is preferably in a range of 700 nm to 1,400 nm. As the light source having a wavelength of 700 nm to 1,400 nm, a solid-state laser or a semiconductor laser that radiates infrared rays is suitable. The output of the infrared laser is preferably 100 mW or greater, the exposure time per one pixel is preferably within 20 µsec, and the irradiation energy quantity is preferably in a range of 10 mJ/cm² to 300 mJ/cm². For the purpose of reducing the exposure time, it is preferable to use a multi-beam laser device. The exposure mechanism may be any of an internal drum system, an external drum system, a flat bed system, and the like. The image exposure can be performed using a plate setter according to a usual method.

### <Development treatment step>

The development treatment can be performed using a typical method. In a case of on-press development, a printing ink receiving unit having a lipophilic surface is formed by the image recording layer in the image area of the image recording layer in a case where at least one of dampening water and printing ink is supplied to the image-exposed lithographic printing plate precursor on a printing press. Meanwhile, in a non-image area, a non-cured image recording layer is dissolved or dispersed by at least any of supplied dampening water and printing ink and then removed, a hydrophilic surface is exposed to the portion. As the result, dampening water adheres to the exposed hydrophilic surface, the printing ink is impressed on the image recording layer of the image area, and then the printing is started. Here, either of dampening water or printing ink may be initially supplied to the surface of the lithographic printing plate precursor, but it is preferable that dampening water is initially supplied thereto so that the on-press developability is promoted by permeation of the dampening water.

### <Printing step>

The printing using the obtained lithographic printing plate can be performed according to a typical method. The printing can be performed by supplying desired printing ink and dampening water, as necessary, to the lithographic printing plate.

The amount of the printing ink and dampening water to be supplied is not particularly limited and may be appropriately set according to the desired printing.

The method of supplying the printing ink and dampening water to the lithographic printing plate is not particularly limited and a known method can be used.

The lithographic printing method according to the present disclosure may include known steps other than the above-described steps. Examples of other steps include a plate inspection step of confirming the position or orientation of the lithographic printing plate precursor before each step and a confirmation step of confirming the printed image after the development treatment step.

### -Development treatment using developer-

Further, a lithographic printing plate can be produced from the lithographic printing plate precursor according to the embodiment of the present disclosure through a development treatment using a developer by appropriately selecting the binder polymer or the like that is the constituent component of the image recording layer.

The method of producing a lithographic printing plate according to the embodiment of the present disclosure preferably includes an exposure step of image-wise exposing the lithographic printing plate precursor according to the embodiment of the present disclosure to form an exposed area and an unexposed area and a development step of supplying a developer having a pH of 2 or higher and 11 or lower to remove the unexposed area.

Further, the lithographic printing method according to the present disclosure preferably includes an exposure step of image-wise exposing the lithographic printing plate precursor according to the embodiment of the present disclosure to form an exposed area and an unexposed area, a development step of supplying a developer having a pH of 2 or higher and 11 or lower to remove the unexposed area, and a step of performing printing using the obtained lithographic printing plate.

The development treatment using a developer includes an aspect in which a developer including an alkaline agent and having a high pH of 14 or lower is used (also referred to as alkali development) and an aspect in which a developer containing at least one compound selected from the group consisting of a surfactant and a water-soluble polymer compound and having a pH of approximately 2 to 11 is used (also referred to as simple development). A preferable embodiment of the method of producing a lithographic printing plate according to the embodiment of the present disclosure is an aspect in which a developer having a pH of approximately 2 to 11 is used.

In a development treatment of the related art in which an alkali developer is used, for example, the protective layer is removed by a pre-water washing step, next, alkali development (development treatment) is performed, alkali is removed by water washing in a post-water washing step, a gum solution treatment is performed, and drying is performed in a drying step. In contrast, in the method of producing a lithographic printing plate according to the embodiment of the present disclosure, in a case where the lithographic printing plate precursor has a protective layer, the protective layer is also removed at the same time, and thus it becomes possible to omit the pre-water washing step.

In addition, it is also possible to perform development and a gum solution treatment step at the same time by adding a water-soluble polymer compound to the developer as necessary. Therefore, the post-water washing step is not particularly required, and it is also preferable to perform development and the gum solution treatment step by a single one-solution step and then perform a drying step described below. After the development treatment, it is preferable to remove the excess developer using a squeeze roller and then perform drying.

That is, in the development step of the method of producing a lithographic printing plate according to the embodiment of the present disclosure, it is preferable to perform the development treatment and the gum solution treatment by a single one-solution step.

Development and the gum solution treatment being performed by a single one-solution step means that the development treatment and the gum solution treatment are not performed as separate steps, and, instead, the water-soluble polymer compound described below is added to the developer, and the development treatment and the gum solution treatment are performed in a single step using one solution which is the developer.

The development treatment in the present disclosure can be suitably performed using an automatic development treatment machine including means for supplying the developer and a rubbing member. An automatic development treatment machine in which a rotary brush roll is used as the rubbing member is particularly preferable.

The number of the rotary brush rolls is preferably two or more. Further, the automatic development treatment machine preferably includes, after development treatment means, means for removing the excess developer such as a squeeze roller or drying means such as a hot-air device. Further, the automatic development treatment machine may include, before the development treatment means, preheating means for performing a heating treatment on the lithographic printing plate precursor after image exposure.

A treatment in such an automatic development treatment machine has an advantage of being released from a need for so-called dealing with development scum derived from the protective layer/a photosensitive layer which is generated in the case of on-press development treatment.

In the development step, in the case of a manual treatment, as a development treatment method, for example, a method in which sponge or absorbent cotton is soaked with an aqueous solution, the entire plate surface is treated while being rubbed and dried after the end of the treatment is suitably exemplified. In the case of an immersion treatment, for example, a method in which the lithographic printing plate precursor is immersed and stirred for 60 seconds in a vat or deep tank containing an aqueous solution and then dried while being rubbed with absorbent cotton, sponge, or the like is suitably exemplified.

In the development treatment, a device having a simplified structure and simplified steps is preferably used.

In development treatments of the related art, the protective layer is removed by the pre-water washing step, next, development is performed using an alkaline developer, after that, alkali is removed in the post-water washing step, a gum treatment is performed in a gum pulling step, and drying is performed in the drying step.

As described above, in the present disclosure, development and gum pulling can be performed at the same time using one solution. Therefore, it becomes possible to omit the post-water washing step and the gum treatment step, and it is preferable to perform the drying step as necessary after development and gum pulling (gum solution treatment) are performed using one solution. As gum, polymers, more preferably, a water-soluble polymer compound and a surfactant are exemplified.

Further, it is preferable to perform the removal of the protective layer, development, and gum pulling at the same time using one solution without performing the pre-water washing step. Further, it is preferable to remove the excess developer using a squeeze roller after development and gum pulling, and then perform drying.

In the above-described removal step (development treatment step) in the present disclosure, a method of immersing the lithographic printing plate precursor in the developer once may be used, or a method of immersing the lithographic printing plate precursor in the developer twice or more may be used. Among them, the method of immersing the lithographic printing plate precursor in the developer once or twice is preferably exemplified.

In the immersion, the exposed lithographic printing plate precursor may be put into a developer tank in which the developer is stored or the developer is blown onto the plate surface of the exposed lithographic printing plate precursor from a spray or the like.

Further, in the present disclosure, even in a case of immersing the lithographic printing plate precursor in the developer twice or more, a case where the lithographic printing plate precursor is immersed in the same developer or the developer and a developer (fatigued solution) in which the components of the image recording layer are dissolved or dispersed by the development treatment twice or more is referred to as the development treatment using one solution (one-solution treatment).

Further, in the development treatment, a rubbing member is preferably used, and a rubbing member such as a brush is preferably installed in a development bath for removing the non-image area of the image recording layer.

The development treatment in the present disclosure can be performed according to a usual method at a temperature of preferably at 0°C to 60°C and more preferably 15°C to 40°C by, for example, immersing the exposed lithographic printing plate precursor in the developer and rubbing the lithographic printing plate precursor with a brush or drawing a treatment liquid prepared in an external tank using a pump, blowing the developer from a spray nozzle, and rubbing the lithographic printing plate precursor with the brush. The development treatment can be continuously performed a plurality of times. For example, the development treatment can be performed by drawing the developer prepared in an external tank using a pump, blowing the developer from a spray nozzle, rubbing the lithographic printing plate precursor with the brush, then, again, blowing the developer from the spray nozzle, and rubbing the lithographic printing plate precursor with the brush. In the case of performing the development treatment using an automatic developing machine, the developer is fatigued as the treatment amount increases, and thus it is preferable to restore the treatment capability by using a supplementary solution or a fresh developer.

In the development treatment in the present disclosure, a gum coater or an automatic developing machine known for the use for a presensitized plate (PS plate) or a computer to plate (CTP) in the related art can also be used. In the case of using the automatic developing machine, it is possible to apply any method of, for example, a method of treating the lithographic printing plate precursor by drawing a developer prepared in a developer tank or a developer prepared in an external tank using a pump and blowing the developer from a spray nozzle, a method of treating the lithographic printing plate precursor by immersing and transporting the printing plate in a tank filled with a developer using a guide roll in the developer or the like, or a so-called single-use treatment method of treating the lithographic printing plate precursor by supplying only a necessary amount of a substantially unused developer to each plate. In any method, it is more preferable to use a rubbing mechanism such as a brush, molleton, or the like. For example, commercially available automatic developing machines (Clean Out Unit C85/C125, Clean-Out Unit+ C85/120, FCF 85V, FCF 125V, FCF News (manufactured by Glunz & Jensen), Azura CX85, Azura CX125, and Azura CX150 (manufactured by AGFA Graphics N.V)) can be used. Further, it is also possible to use a device into which a laser exposure unit and an automatic developing machine unit are integrally combined.

The details of each component of the developer used in the development step will be described below.

### [pH]

The pH of the developer used in the present disclosure is 2 or higher and 11 or lower, preferably 5 or higher and 9 or lower, and more preferably 7 or higher and 9 or lower. From the viewpoint of developability or dispersibility of the image recording layer, it is advantageous to the value of the pH to be high; however, regarding printability, particularly, stain suppression, it is advantageous to set the value of the pH to be low.

In the present disclosure, the pH is a value measured at 25°C using a pH meter (model No.: HM-31, manufactured by DKK-TOA Corporation).

### [Surfactant]

The developer used in the present disclosure may contain a surfactant such as an anionic surfactant, a non-ionic surfactant, a cationic surfactant, and an amphoteric surfactant.

Among them, from the viewpoint of brush stain property, the developer preferably contains at least one selected from the group consisting of an anionic surfactant and an amphoteric surfactant.

Further, the developer preferably contains a non-ionic surfactant and more preferably contains a non-ionic surfactant and at least one selected from the group consisting of an anionic surfactant and an amphoteric surfactant.

Preferred examples of the anionic surfactant include a compound represented by the Formula (I).

R¹-Y¹-X¹ (I)

In Formula (I), R¹ represents an alkyl group, a cycloalkyl group, an alkenyl group, an aralkyl group, or an aryl group, which may have a substituent.

As the alkyl group, for example, an alkyl group having 1 to 20 carbon atoms is preferable, and preferred specific examples thereof include a methyl group, an ethyl group, a propyl group, an n-butyl group, a sec-butyl group, a hexyl group, a 2-ethylhexyl group, an octyl group, a decyl group, a dodecyl group, a hexadecyl group, and a stearyl group.

The cycloalkyl group may be monocyclic or polycyclic. As the monocyclic cycloalkyl group, a monocyclic cycloalkyl group having 3 to 8 carbon atoms is preferable, and a cyclopropyl group, a cyclopentyl group, a cyclohexyl group, or a cyclooctyl group is more preferable. Preferred examples of the polycyclic cycloalkyl group include an adamantyl group, a norbornyl group, an isobornyl group, a camphanyl group, a dicyclopentyl group, an α-pinel group, and a tricyclodecanyl group.

As the alkenyl group, for example, an alkenyl group having 2 to 20 carbon atoms is preferable, and preferred specific examples thereof include a vinyl group, an allyl group, a butenyl group, and a cyclohexenyl group.

As the aralkyl group, for example, an aralkyl group having 7 to 12 carbon atoms is preferable, and preferred specific examples thereof include a benzyl group, a phenethyl group, and a naphthylmethyl group.

As the aryl group, for example, an aryl group having 6 to 15 carbon atoms is preferable, and preferred specific examples thereof include a phenyl group, a tolyl group, a dimethylphenyl group, a 2,4,6-trimethylphenyl group, a naphthyl group, an anthryl group, and a 9,10-dimethoxyanthryl group.

As the substituent, a monovalent nonmetallic atomic group excluding a hydrogen atom is used, and preferred examples thereof include a halogen atom (F, Cl, Br, or I), a hydroxy group, an alkoxy group, an aryloxy group, an acyl group, an amide group, an ester group, an acyloxy group, a carboxy group, a carboxylic acid anion group, and a sulfonic acid anion group.

As specific examples of the alkoxy group in the substituent, a methoxy group, an ethoxy group, a propyloxy group, an isopropyloxy group, a butyloxy group, a pentyloxy group, a hexyloxy group, a dodecyloxy group, a stearyloxy group, a methoxyethoxy group, a poly(ethyleneoxy) group, and a poly(propyleneoxy) group, respectively having 1 to 40 carbon atoms, are preferable; and these groups respectively having 1 to 20 carbon atoms are more preferable. Examples of the aryloxy group include a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group, and a naphthyloxy group, respectively having 6 to 18 carbon atoms. Examples of the acyl group include an acetyl group, a propanoyl group, a butanoyl group, a benzoyl group, and a naphthoyl group, respectively having 2 to 24 carbon atoms. Examples of the amide group include an acetamide group, a propionic acid amide group, a dodecanoic acid amide group, a palmitic acid amide group, a stearic acid amide group, a benzoic acid amide group, and a naphthoic acid amide group, respectively having 2 to 24 carbon atoms. Examples of the acyloxy group include an acetoxy group, a propanoyloxy group, a benzoyloxy group, and a naphthoyloxy group, respectively having 2 to 20 carbon atoms. Examples of the ester group include a methyl ester group, an ethyl ester group, a propyl ester group, a hexyl ester group, an octyl ester group, a dodecyl ester group, and a stearyl ester group, respectively having 1 to 24 carbon atoms. The substituent may be formed by combining two or more substituents described above.

X¹ represents a sulfonate group, a sulfate monoester group, a carboxylate group, or a phosphate group.

Y¹ represents a single bond, -CₙH₂ₙ-, -Cₙ₋ₘH₂₍ₙ₋ₘ₎OCₘH₂ₘ-, -O-(CH₂CH₂O)ₙ-, -O-(CH(CH₃)CH₂O)ₙ-, -O-(CH₂CH(CH₃)O)ₙ-, -O-(CH₂CH₂CH₂O)ₙ-, -CO-NH-, or a divalent linking group formed by combining two or more of these, in which the expressions of "n≥1" and "n≥m≥0" is satisfied.

Among examples of the compound represented by Formula (I), from the viewpoint of scratch and stain resistance, a compound represented by Formula (I-A) or Formula (I-B) is preferable.

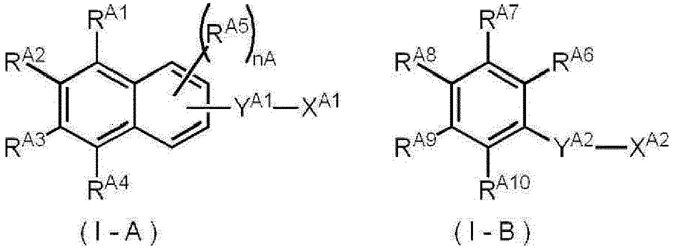

In Formulae (I-A) and (I-B), R^{A1} to R^{A10} each independently represent a hydrogen atom or an alkyl group, nA represents an integer of 1 to 3, X^{A1} and X^{A2} each independently represent a sulfonate group, a sulfate monoester group, a carboxylate group, or a phosphate group, and Y^{A1} and Y^{A2} each independently represent a single bond, -CₙH₂ₙ-, -Cₙ₋ₘH₂₍ₙ₋ₘ₎OCₘH₂ₘ-, -O-(CH₂CH₂O)ₙ-, -O-(CH(CH₃)CH₂O)ₙ-, -O-(CH₂CH(CH₃)O)ₙ-, -O-(CH₂CH₂CH₂O)ₙ-, -CO-NH-, or a divalent linking group formed by combining two or more of these, in which the expressions of "n≥1" and "n≥m≥0" is satisfied. The sum total number of carbon atoms in R^{A1} to R^{A5} or R^{A6} to R^{A10}, and Y^{A1} or Y^{A2} is 3 or greater.

The total number of carbon atoms in R^{A1} to R^{A5} and Y^{A1} or R^{A6} to R^{A10} and Y^{A2} in the compound represented by Formula (I-A) or Formula (I-B) is preferably 25 or less and more preferably in a range of 4 to 20. The structure of the above-described alkyl group may be linear or branched.

It is preferable that X^{A1} and X^{A2} in the compound represented by Formula (I-A) or Formula (I-B) represent a sulfonate group or a carboxylate group. Further, the salt structure in X^{A1} and X^{A2} is preferable from the viewpoint that the solubility of the alkali metal salt in a water-based solvent is particularly excellent. Among the salt structures, a sodium salt or a potassium salt is particularly preferable.

As the compound represented by Formula (I-A) or Formula (I-B), the description in paragraphs 0019 to 0037 ofJP2007-206348Acan be referred to.

As the anionic surfactant, the compounds described in paragraphs 0023 to 0028 of JP2006-065321A can be suitably used.

The amphoteric surfactant used for the developer according to the present disclosure is not particularly limited, and examples thereof include an amine oxide-based surfactant such as alkyl dimethylamine oxide; a betaine-based surfactant such as alkyl betaine, fatty acid amide propyl betaine, or alkyl imidazole; and an amino acid-based surfactant such as sodium alkylamino fatty acid.

Particularly, alkyl dimethylamine oxide which may have a substituent, alkyl carboxy betaine which may have a substituent, or alkyl sulfobetaine which may have a substituent is preferably used. Specific examples thereof include compounds represented by Formula (2) in paragraph 0256 of JP2008-203359A, compounds represented by Formulae (I), Formula (II), and Formula (VI) in paragraph 0028 of JP2008-276166A, and compounds described in paragraphs 0022 to 0029 of JP2009-047927A.

As an amphoteric ion-based surfactant used for the developer, a compound represented by formula (1) or a compound represented by Formula (2) is preferable.

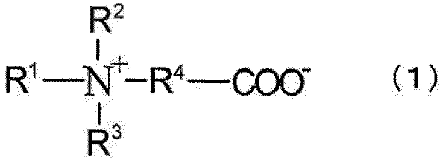

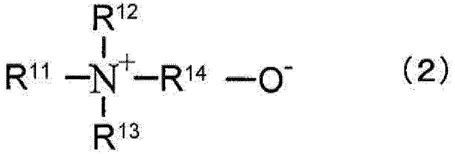

In Formulae (1) and (2), R¹ and R¹¹ each independently represent an alkyl group having 8 to 20 carbon atoms or an alkyl group having a linking group, which has 8 to 20 carbon atoms in total.

R², R³, R¹², and R¹³ each independently represent a hydrogen atom, an alkyl group, or a group containing an ethylene oxide group.

R⁴ and R¹⁴ each independently represent a single bond or an alkylene group.

Further, two groups from among R¹, R², R³, and R⁴ may be bonded to each other to form a ring structure, and two groups from among R¹¹, R¹², R¹³, and R¹⁴ may be bonded to each other to form a ring structure.

In the compound represented by Formula (1) or the compound represented by Formula (2), the hydrophobic portion becomes bigger as the total number of carbon atoms increases, and the solubility in a water-based developer is decreased. In this case, the solubility is improved by mixing an organic solvent such as alcohol that assists dissolution with water as a dissolution assistant, but the surfactant cannot be dissolved within a proper mixing range in a case where the total number of carbon atoms becomes extremely large. Accordingly, the sum total number of carbon atoms of R¹ to R⁴ or R¹¹ to R¹⁴ is preferably in a range of 10 to 40 and more preferably in a range of 12 to 30.

The alkyl group having a linking group represented by R¹ or R¹¹ has a structure in which a linking group is present between alkyl groups. In other words, in a case where one linking group is present, the structure can be represented by "-alkylene group-linking group-alkyl group". Examples of the linking group include an ester bond, a carbonyl bond, and an amide bond. The structure may have two or more linking groups, but it is preferable that the structure has one linking group, and an amide bond is particularly preferable. The total number of carbon atoms of the alkylene group bonded to the linking group is preferably in a range of 1 to 5. The alkylene group may be linear or branched, but a linear alkylene group is preferable. The number of carbon atoms of the alkyl group bonded to the linking group is preferably in a range of 3 to 19, and the alkyl group may be linear or branched, but a linear alkyl is preferable.

In a case where R² or R¹² represents an alkyl group, the number of carbon atoms thereof is preferably in a range of 1 to 5 and particularly preferably in a range of 1 to 3. The alkyl group may be linear or branched, but a linear alkyl group is preferable.

In a case where R³ or R¹³ represents an alkyl group, the number of carbon atoms thereof is preferably in a range of 1 to 5 and particularly preferably in a range of 1 to 3. The alkyl group may be linear or branched, but a linear alkyl group is preferable.

Examples of the group containing an ethylene oxide represented by R³ or R¹³ include a group represented by -R^{a}(CH₂CH₂O)ₙR^{b}. Here, R^{a} represents a single bond, an oxygen atom, or a divalent organic group (preferably having 10 or less carbon atoms), R^{b} represents a hydrogen atom or an organic group (preferably having 10 or less carbon atoms), and n represents an integer of 1 to 10.

In a case where R⁴ and R¹⁴ represents an alkylene group, the number of carbon atoms thereof is preferably in a range of 1 to 5 and particularly preferably in a range of 1 to 3. The alkylene group may be linear or branched, but a linear alkylene group is preferable.

The compound represented by Formula (1) or the compound represented by Formula (2) preferably has an amide bond and more preferably has an amide bond as a linking group of R¹ or R¹¹.

Representative examples of the compound represented by Formula (1) or the compound represented by Formula (2) are as follows, but the present disclosure is not limited thereto.

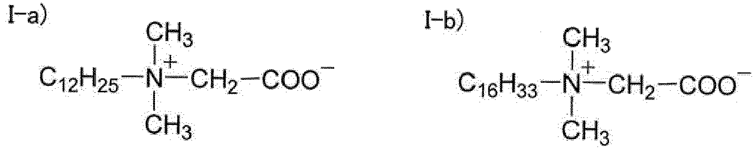

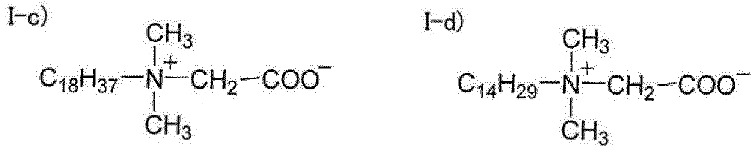

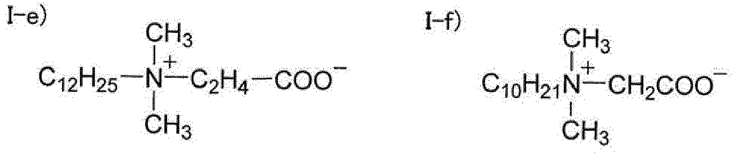

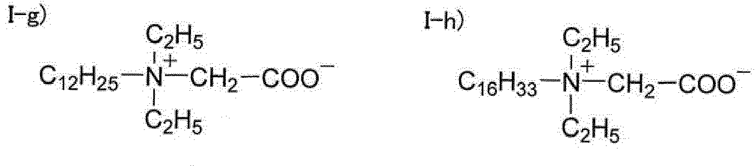

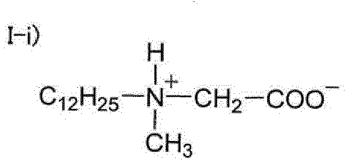

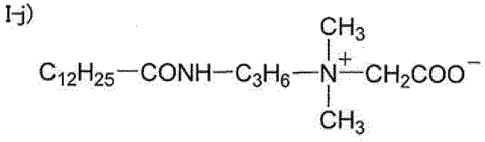

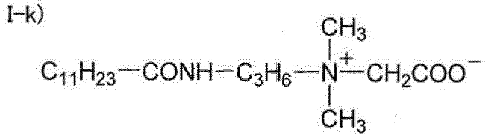

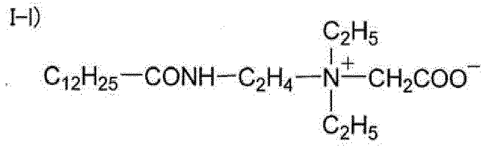

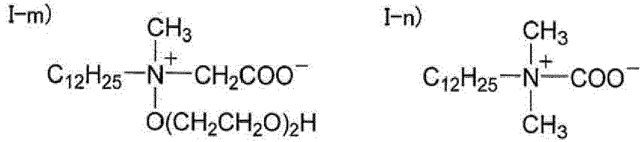

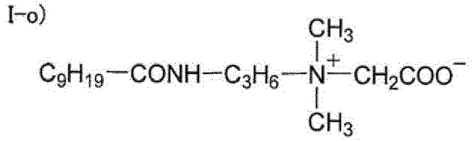

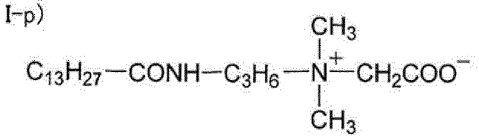

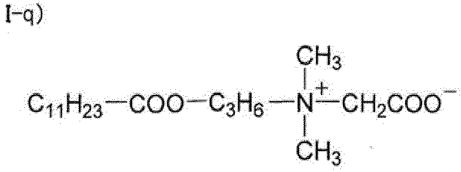

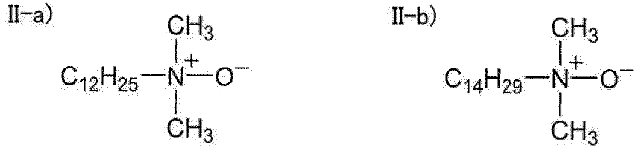

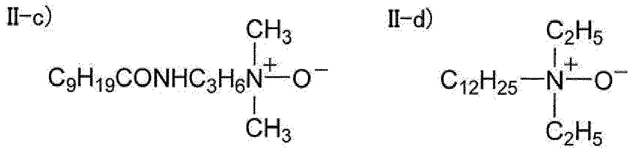

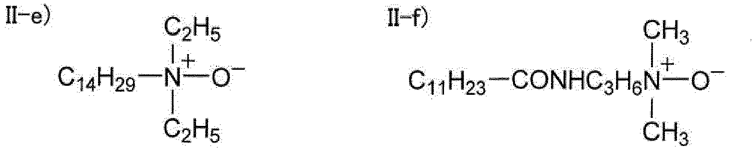

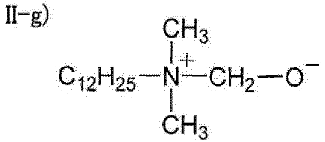

The compound represented by Formula (1) or Formula (2) can be synthesized according to a known method. Further, commercially available products may be used. Examples of the commercially available products of the compound represented by Formula (1) include SOFRAZOLINE LPB, SOFTAZOLINE LPB-R, and VISTA MAP (manufactured by Kawaken Fine Chemicals Co., Ltd.), and TAKESAAF C-157L (manufactured by TAKEMOTO OIL & FAT Co., Ltd.). Examples of the commercially available products of the compound represented by Formula (2) include SOFTAZOLINE LAO (manufactured by Kawaken Fine Chemicals Co., Ltd.) and AMOGEN AOL (manufactured by DKS Co., Ltd.).

The amphoteric ion-based surfactant may be used alone or in combination of two or more kinds thereof in a developer.

Examples of non-ionic surfactant include polyoxyethylene alkyl ethers, polyoxyethylene alkyl phenyl ethers, polyoxyethylene polystyryl phenyl ether, glycerin fatty acid partial esters, sorbitan fatty acid partial esters, pentaerythritol fatty acid partial esters, propylene glycol monofatty acid ester, sucrose fatty acid partial ester, polyoxyethylene sorbitan fatty acid partial esters, polyoxyethylene sorbitol fatty acid partial esters, polyethylene glycol fatty acid esters, polyglycerin fatty acid partial esters, polyoxyethylene glycerin fatty acid partial esters, polyoxyethylene diglycerins, fatty acid diethanolamides, N,N-bis-2-hydroxyalkylamines, polyoxyethylene alkylamine, triethanolamine fatty acid ester, trialkylamine oxide, polyoxyethylene alkyl phenyl ethers, and polyoxyethylene-polyoxypropylene block copolymers.

Further, acetylene glycol-based and acetylene alcohol-based oxyethylene addition products, and fluorine-based surfactants can also be used. These surfactants can be used in combination of two or more kinds thereof.

Particularly preferred examples of the non-ionic surfactant include a non-ionic aromatic ether-based surfactant represented by Formula (N1).

X^{N}-Y^{N}-O-(A¹)_{nB}-(A²)_{mB}-H (N1)

In the formula, X^{N} represents an aromatic group which may have a substituent, Y^{N} represents a single bond or an alkylene group having 1 to 10 carbon atoms, A¹ and A² are different groups and represent any of -CH₂CH₂O- or -CH₂CH(CH₃)O-, and nB and mB each independently represent an integer of 0 to 100, provided that both of nB and mB is not 0 at the same time, and both of nB and mB is not 1 in a case where any one of nB or mB is 0.

In the formula, examples of the aromatic group of X^{N} include a phenyl group, a naphthyl group, and an anthranyl group. These aromatic groups may have a substituent. Examples of the substituent include an organic group having 1 to 100 carbon atoms. Further, in the formula, the compound may be a random or block copolymer in a case where both A¹ and A² are present.

Specific examples of the organic group having 1 to 100 carbon atoms include aliphatic hydrocarbon groups or aromatic hydrocarbon groups, which may be saturated or unsaturated and may be linear or branched, such as an alkyl group, an alkenyl group, an alkynyl group, an aryl group, an aralkyl group, an alkoxy group, an aryloxy group, a N-alkylamino group, a N,N-dialkylamino group, a N-arylamino group, a N,N-diarylamino group, a N-alkyl-N-arylamino group, an acyloxy group, a carbamoyloxy group, a N-alkylcarbamoyloxy group, a N-arylcarbamoyloxy group, a N,N-dialkylcarbamoyloxy group, a N,N-diarylcarbamoyloxy group, a N-alkyl-N-arylcarbamoyloxy group, an acylamino group, a N-alkylacylamino group, a N-arylacylamino group, an acyl group, an alkoxycarbonylamino group, an alkoxycarbonyl group, an aryloxycarbonyl group, a carbamoyl group, a N-alkylcarbamoyl group, a N,N-dialkylcarbamoyl group, a N-arylcarbamoyl group, a N,N-diarylcarbamoyl group, a N-alkyl-N-arylcarbamoyl group, a polyoxyalkylene chain, and the above-described organic group to which a polyoxyalkylene chain is bonded. The alkyl group may be linear or branched.

Further, as the non-ionic surfactant, compounds described in paragraphs 0030 to 0040 of JP2006-065321A can also be suitably used.

The cationic surfactant is not particularly limited, and known surfactants of the related art can be used. Examples thereof include alkylamine salts, quaternary ammonium salts, alkylimidazolinium salts, polyoxyethylene alkylamine salts, and polyethylene polyamine derivatives.

The surfactant may be used alone or in combination of two or more kinds thereof.

The content of the surfactant is preferably in a range of 1% by mass to 25% by mass, more preferably in a range of 2% by mass to 20% by mass, still more preferably in a range of 3% by mass to 15% by mass, and particularly preferably in a range of 5% by mass to 10% by mass with respect to the total mass of the developer. In a case where the content thereof is in the above-described range, scratch and stain resistance is excellent, the dispersibility of the development scum is excellent, and the inking property of a lithographic printing plate to be obtained is excellent.

### [Water-soluble polymer compound]

The developer used in the present disclosure is capable of containing a water-soluble polymer from the viewpoint of the viscosity adjustment of the developer and the protection of the plate surface of a lithographic printing plate to be obtained.

Examples of the water-soluble polymer include a water-soluble polymer compound such as soybean polysaccharides, modified starch, gum arabic, dextrin, a fiber derivative (such as carboxymethyl cellulose, carboxyethyl cellulose, or methyl cellulose) and a modified product thereof, pullulan, polyvinyl alcohol and a derivative thereof, a copolymer of polyvinylpyrrolidone, polyacrylamide and acrylamide, a vinyl methyl ether/maleic anhydride copolymer, a vinyl acetate/maleic acid anhydride copolymer, and a styrene/maleic anhydride copolymer.

As the soybean polysaccharides, soybean polysaccharides which have been known in the related art can be used. For example, SOYAFIBE (trade name, manufactured by FUJI OIL, CO., LTD.) can be used as a commercially available product, and various grades of products can be used. Preferred examples thereof include products in which the viscosity of a 10% by mass aqueous solution is in a range of 10 mPa·s to 100 mPa·s.

As the modified starch, starch represented by Formula (III) is preferable. Any of starch such as corn, potato, tapioca, rice, or wheat can be used as the starch represented by Formula (III). The modification of the starch can be performed according to a method of decomposing the starch with an acid or an enzyme to have 5 to 30 glucose residues per one molecule and adding oxypropylene thereto in an alkali.

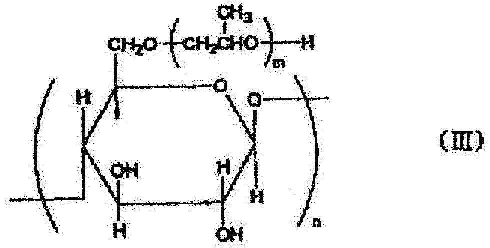

In the formula, the etherification degree (degree of substitution) is in a range of 0.05 to 1.2 per glucose unit, n represents an integer of 3 to 30, and m represents an integer of 1 to 3.

Among the examples of the water-soluble polymer compound, soybean polysaccharides, modified starch, gum arabic, dextrin, carboxymethyl cellulose, and polyvinyl alcohol are particularly preferable.

The water-soluble polymer compound can be used in combination of two or more kinds thereof.

It is preferable that the developer does not contain the water-soluble polymer compound or the content of the water-soluble polymer compound is more than 0% by mass and 1% by mass or less with respect to the total mass of the developer, it is more preferable that the developer does not contain the water-soluble polymer compound or the content of the water-soluble polymer compound is more than 0% by mass and 0.1% by mass or less with respect to the total mass of the developer, it is still more preferable that the developer does not contain the water-soluble polymer compound or the content of the water-soluble polymer compound is more than 0% by mass and 0.05% by mass or less with respect to the total mass of the developer, and it is particularly preferable that the developer does not contain the water-soluble polymer compound. In the case of the above-described aspect, the viscosity of the developer is appropriate, and it is possible to suppress the development scum or the like being deposited on a roller member of the automatic developing machine.

### [Other additives]

The developer used in the present disclosure may contain a wetting agent, a preservative, a chelate compound, an antifoaming agent, an organic acid, an organic solvent, an inorganic acid, and an inorganic salt in addition to those described above.

Suitable examples of the wetting agent include ethylene glycol, propylene glycol, triethylene glycol, butylene glycol, hexylene glycol, diethylene glycol, dipropylene glycol, glycerin, glycerin, trimethylolpropane, and diglycerin. The wetting agent may be used alone or in combination of two or more kinds thereof. The content of the wetting agent is preferably in a range of 0.1% by mass to 5% by mass with respect to the total mass of the developer.

As the preservative, phenol or a derivative thereof, formalin, an imidazole derivative, sodium dehydroacetate, a 4-isothiazolin-3-one derivative, benzoisothiazolin-3-one, 2-methyl-4-isothiazolin-3-one, a benzotriazole derivative, an amidizing anidine derivative, quaternary ammonium salts, derivatives of pyridine, quinoline, and guanidine, diazine, a triazole derivative, oxazole, an oxazine derivative, nitrobromoalcohol such as 2-bromo-2-nitropropane-1,3-diol, 1,1-dibromo -1-nitro-2-ethanol, and 1,1-dibromo-1-nitro-2-propanol, and the like can be preferably used.

The addition amount of the preservative is an amount of stably exhibiting the efficacy for bacteria, molds, yeasts, or the like, and is preferably in a range of 0.01% by mass to 4% by mass with respect to the total mass of the developer, even though the amount thereof varies depending on the type of bacteria, molds, and the yeasts. Further, two or more preservatives are preferably used in combination so that there is efficacy for a variety of molds and bacteria.

Examples of the chelate compound include ethylenediaminetetraacetic acid, a potassium salt thereof, and a sodium salt thereof; diethylenetriaminepentaacetic acid, a potassium salt thereof, and a sodium salt thereof; triethylenetetraminehexaacetic acid, a potassium salt thereof, a sodium salt thereof; hydroxyethylethylenediaminetriacetic acid, a potassium salt thereof, and a sodium salt thereof; nitrilotriacetic acid and a sodium salt thereof; 1-hydroxyethane-1,1-diphosphonic acid, a potassium salt thereof, and a sodium salt thereof; and organic phosphonic acids such as aminotri(methylenephosphonic acid), a potassium salt thereof, and sodium salt thereof. Instead of the sodium salt and the potassium salt of the chelating agent, a salt of an organic amine is also effective.

These chelating agents are preferably a chelating agent that is stably present in a treatment liquid composition and does not impair printability. The content of the chelating agent is preferably in a range of 0.001% by mass to 1.0% by mass with respect to the total mass of the developer.

As the antifoaming agent, it is possible to use a typical silicone-based self-emulsification type, emulsification type, or non-ionic compound having a hydrophilic-lipophilic balance (HLB) of 5 or lower or the like. A silicone antifoaming agent is preferable.

Further, in the present disclosure, a silicone-based surfactant is regarded as the antifoaming agent.

The content of the antifoaming agent is suitably in a range of 0.001% by mass to 1.0% by mass with respect to the total mass of the developer.

Examples of the organic acid include citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, and organic phosphonic acid. The organic acid can be used in the form of an alkali metal salt or ammonium salt thereof. The content of the organic acid is preferably in a range of 0.01% by mass to 0.5% by mass with respect to the total mass of the developer.

Examples of a containable organic solvent include aliphatic hydrocarbons (hexane, heptane, "ISOPAR E, H, G" (manufactured by Exxon Mobil Corporation), gasoline, kerosene, and the like), aromatic hydrocarbons (toluene, xylene, and the like), halogenated hydrocarbon (methylene dichloride, ethylene dichloride, trichlene, monochlorobenzene, and the like), and polar solvents.

Examples of the polar solvent include alcohols (such as methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol, and methyl amyl alcohol), ketones (such as acetone, methyl ethyl ketone, ethyl butyl ketone, methyl isobutyl ketone, and cyclohexanone), esters (such as ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, and butyl levulinate), and others (such as triethyl phosphate, tricresyl phosphate, N-phenylethanolamine, and N-phenyldiethanolamine).

In a case where the organic solvent is insoluble in water, the organic solvent can be used by being solubilized in water using a surfactant or the like. In a case where the developer contains an organic solvent, from the viewpoints of safety and inflammability, the concentration of the solvent in the developer is preferably less than 40% by mass.

Examples of the inorganic acid and inorganic salt include phosphoric acid, methacrylic acid, primary ammonium phosphate, secondary ammonium phosphate, primary sodium phosphate, secondary sodium phosphate, primary potassium phosphate, secondary potassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogensulfate, and nickel sulfate. The content of the inorganic salt is preferably in a range of 0.01% by mass to 0.5% by mass with respect to the total mass of the developer.

The developer used in the present disclosure is obtained by dissolving or dispersing each of the above-described components in water as necessary. The concentration of solid contents of the developer is preferably in a range of 2% by mass to 25% by mass. Further, the developer can be used by preparing a concentrated solution and diluting the concentrate with water at the time of use.

Further, it is preferable that the developer used in the present disclosure is an aqueous developer.

Further, from the viewpoint of the dispersibility of the development scum, the developer used in the present disclosure preferably contains an alcohol compound.

Examples of the alcohol compound include methanol, ethanol, propanol, isopropanol, and benzyl alcohol. Among these, benzyl alcohol is preferable.

From the viewpoint of the dispersibility of the development scum, the content of the alcohol compound is preferably 0.01% by mass to 5% by mass, more preferably 0.1% by mass to 2% by mass, and particularly preferably 0.2% by mass to 1% by mass with respect to the total mass of the developer.

### Examples

Hereinafter, the present disclosure will be described in detail with reference to examples, but the present disclosure is not limited thereto. In the present examples, "%" and "parts" respectively indicate "% by mass" and "parts by mass" unless otherwise specified. Further, in a polymer compound, the molecular weight indicates the weight-average molecular weight (Mw) and the proportion of constitutional units indicates mole percentage unless otherwise specified. Further, the weight-average molecular weight (Mw) is a value in terms of polystyrene obtained by performing measurement using gel permeation chromatography (GPC) method.

### (Examples 1 to 44 and Comparative Examples 1 to 3)

### <Production of support>

In order to remove rolling oil on the surface of a 0.3 mm-thick aluminum plate (material JIS A 1050), a defatting treatment was performed thereon using a 10% by mass aqueous solution of sodium aluminate at 50°C for 30 seconds, and then the surface of the aluminum plate was grained using three implanted nylon brushes having a hair diameter of 0.3 mm and an aqueous suspension (specific gravity: 1.1 g/cm³) of pumice having a median diameter of 25 µm and well washed with water. The aluminum plate was etched by being immersed in a 25% by mass aqueous solution of sodium hydroxide at 45°C for nine seconds, washed with water, further immersed in a 20% by mass aqueous solution of nitric acid at 60°C for 20 seconds, and then washed with water. The etching amount of the grained surface was approximately 3 g/m².

Next, an electrochemical roughening treatment was continuously performed using an AC voltage of 60 Hz. An electrolyte was a 1% by mass aqueous solution of nitric acid (including 0.5% by mass of aluminum ions), and the solution temperature was 50°C. Using a trapezoidal rectangular waveform AC having a time tp, until the current value reached a peak from zero, of 0.8 ms and the duty ratio of 1:1 as the AC power source waveform, the electrochemical roughening treatment was performed using a carbon electrode as a counter electrode. As an auxiliary anode, ferrite was used. The current density was 30 A/dm² as the peak current value, and 5% of the current from the power source was separately flowed to the auxiliary anode. The electric quantity in nitric acid electrolysis was 175 C/dm² as the electric quantity at the time of anodization of the aluminum plate. Thereafter, washing with water by spraying was performed.

Next, an electrochemical roughening treatment was performed according to the same method as that for the nitric acid electrolysis using a 0.5% by mass of hydrochloric acid aqueous solution (containing 0.5% by mass of aluminum ions) and an electrolyte having a solution temperature of 50°C under a condition of an electric quantity of 50 C/dm² at the time of anodization of the aluminum plate, and washing with water was performed using a spray.

Next, 2.5 g/m² of a DC anodized film was formed on the aluminum plate at a current density of 15 A/dm² using a 15% by mass aqueous solution of sulfuric acid (including 0.5% by mass of aluminum ions) as an electrolyte and then washed with water and dried, thereby producing a support. The average pore diameter in the surface layer of the anodized film (surface average pore diameter) was 10 nm.

The pore diameter in the surface layer of the anodized film was measured using a method in which the surface was observed an ultrahigh resolution SEM (S-900 manufactured by Hitachi, Ltd.) at a relatively low acceleration voltage of 12 V at a magnification of 150,000 times without carrying out a vapor deposition treatment or the like for imparting conductive properties, 50 pores were randomly extracted, and the average value was obtained. The standard deviation was ±10% or less of the average value.

### <Formation of image recording layer>

The support was coated with an undercoating solution (1) having the following composition so that a dried coating amount was set to 20 mg/m² and dried in an oven at 100°C for 30 seconds, thereby producing a support having an undercoat layer.

The undercoat layer was bar-coated with the following image recording layer coating solution and dried in the oven at 100°C for 60 seconds, thereby forming an image recording layer having a dried coating amount of 1.0 g/m².

Thereafter, the image recording layer was coated with an overcoat layer coating solution having the following composition and dried in an oven at 100°C for 60 seconds, thereby forming an overcoat layer having a dried coating amount of 0.1 g/m² and thus obtaining a lithographic printing plate precursor.

### [Undercoating solution (1)]

· Undercoating compound 1 described below: 0.18 parts
· Methanol: 55.24 parts
· Distilled water: 6.15 parts

### -Synthesis of undercoating compound 1-

### «Purification of monomer M-1»

LIGHT ESTER P-1M (2-methacryloyloxyethyl acid phosphate, manufactured by Kyoeisha Chemical Co., Ltd.) (420 parts), diethylene glycol dibutyl ether (1,050 parts), and distilled water (1,050 parts) were added to a separating funnel, strongly stirred, and then allowed to stand. The upper layer was disposed of, diethylene glycol dibutyl ether (1,050 parts) was added thereto, and the components were strongly stirred and then allowed to stand. The upper layer was disposed of, thereby obtaining an aqueous solution of a monomer M-1 (1,300 parts, 10.5% by mass expressed in terms of solid contents).

### <<Synthesis of undercoating compound 1»

Distilled water (53.73 parts) and the monomer M-2 (3.66 parts) shown below were added to a three-neck flask and heated to 55°C in a nitrogen atmosphere. Next, the dropping solution 1 described below was added dropwise thereto for two hours, the components were stirred for 30 minutes, VA-046B (manufactured by Wako Pure Chemical Industries Ltd.) (0.386 parts) was added thereto, and then the components were heated to 80°C and stirred for 1.5 hours. The reaction solution was returned to room temperature (25°C), a 30% by mass aqueous solution of sodium hydroxide was added thereto so as to adjust pH to 8.0, and then 4-hydroxy-2,2,6,6-tetramethylpiperidine-1-oxyl (4-OH-TEMPO, 0.005 parts) was added thereto. An aqueous solution of an undercoating compound 1 (180 parts) was obtained by the above-described operation. The weight-average molecular weight (Mw) in terms of polyethylene glycol value by the gel permeation chromatography (GPC) method was 170,000.

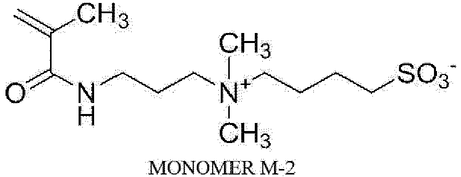

### <<Dropping solution 1»

· Aqueous solution of the monomer M-1 described above: 87.59 parts
· Monomer M-2 described above: 14.63 parts
· VA-046B (2,2'-azobis[2-(2-imidazolin-2-yl)propane] disulfate dehydrate, manufactured by Wako Pure Chemical Industries Ltd.): 0.386 parts
· Distilled water: 20.95 parts

### <Image forming layer coating solution (1)>

· Polymerizable compound 1^{∗1}: 0.325 parts
· Graft copolymer 1^{∗2}: 0.060 parts
· Graft copolymer 2^{∗3}: 0.198 parts
· Mercapto-3-triazole^{∗4}: 0.180 parts
· Irgacure 250^{∗5}: 0.032 parts
· Infrared absorbent 1 (the following structure): 0.007 parts
· Sodium tetraphenylborate: 0.04 parts
· Byk 336^{∗7}: 0.015 parts
· n-propanol: 7.470 parts
· Water: 1.868 parts
*1: Dipentaerythritol hexaacrylate (manufactured by Shin Nakamura Chemical Industry Co., Ltd.)
*2: The graft copolymer 1 is a polymer grafted by poly(oxy-1,2-ethanediyl), α-(2-methyl-1-oxo-2-propenyl)-ω-methoxy-, and ethenylbenzene, and a dispersion containing 25% by mass of the polymer particles in a solvent containing n-propanol and water at a mass ratio of 80:20 is used.
*3: The graft copolymer 2 is a polymer particle of a graft copolymer of poly(ethylene glycol)methyl ether methacrylate, styrene, and acrylonitrile at a mixing ratio of 10:9:81, and a dispersion containing 24% by mass of the polymer particles in a solvent containing n-propanol and water at a mass ratio of 80:20 is used. Further, the volume average particle diameter is 193 nm.
*4: Mercapto-3-triazole indicates mercapto-3-triazole-1H,2,4 which is commercially available from PCAS (France).
*5: Irgacure 250 is a 75% propylene carbonate solution of iodonium (4-methylphenyl)[4-(2-methylpropyl)phenyl]-hexafluorophosphate that can be procured from Ciba Specialty Chemicals Inc.
*7: Byk 336 is a modified dimethyl polysiloxane copolymer which is commercially available from BYK-Chemie Japan K. K., in a 25% xylene/methoxypropyl acetate solution.

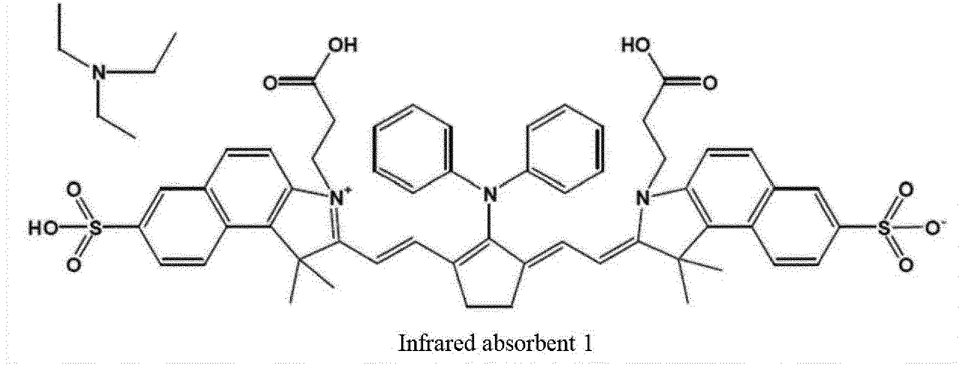

### <Image forming layer coating solution (2)>

· Binder polymer (1) [the following structure]: 0.240 parts
· Infrared absorbent (2) [the following structure]: 0.030 parts
· Polymerization initiator (1) [the following structure]: 0.162 parts
· Polymerizable compound (Tris(acryloyloxyethyl) isocyanurate, NK ESTER A-9300, manufactured by Shin-Nakamura Chemical Co., Ltd.): 0.192 parts
· Tris(2-hydroxyethyl) isocyanurate: 0.062 parts
· Benzyl-dimethyl-octyl ammonium·PF₆ salt: 0.018 parts
· Ammonium group-containing polymer [a structure of the following reference sign (15)]: 0.010 parts
· Fluorine-based surfactant (1) [the following structure]: 0.008 parts
· Methyl ethyl ketone: 1.091 parts
· 1-methoxy-2-propanol: 8.609 parts
· Microgel solution (1) [prepared by the following method]: 5.065 parts

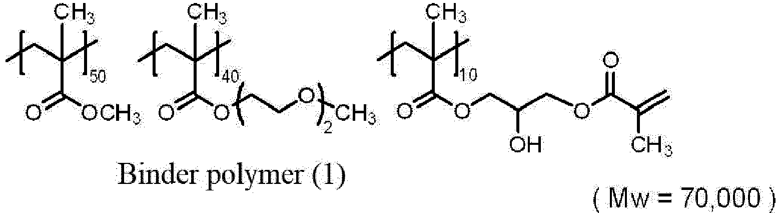

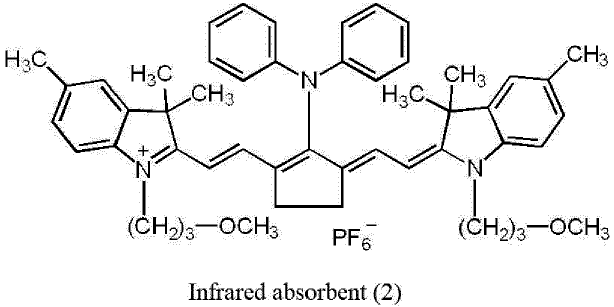

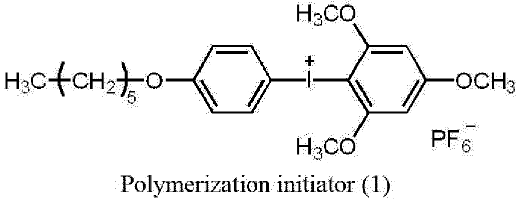

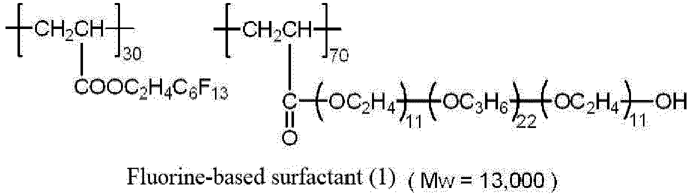

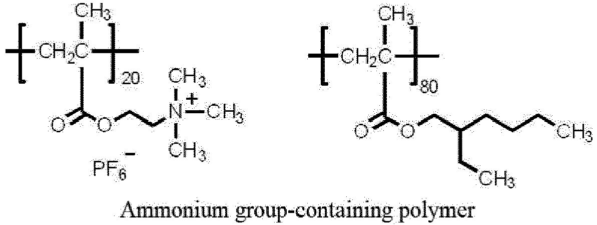

### <Microgel solution (1)>

· Microgel (1) [prepared by the following method]: 2.640 parts
· Distilled water: 2.425 parts

A method of preparing a microgel (1) used for the preparation of the microgel solution (1) will be described below.

### <Preparation of polyvalent isocyanate compound (1)>

0.043 parts of bismuth tris(2-ethylhexanoate) (NEOSTANN U-600, manufactured by NITTO KASEI CO., LTD.) was added to an ethyl acetate (25.31 parts) suspension solution of 17.78 parts of isophorone diisocyanate and 7.35 parts of the following polyhydric phenol compound (1), and the solution was stirred. The reaction temperature was set to 50°C at the time of heat generation being subsided, and the solution was stirred for 3 hours, thereby obtaining an ethyl acetate solution (50% by mass) of a polyvalent isocyanate compound (1).

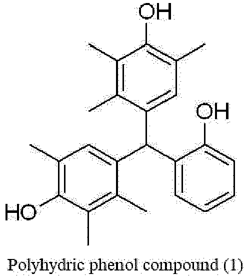

### <Preparation of microgel (1)>

The following oil phase components and the water phase component were mixed with each other and emulsified at 12,000 rpm for 10 minutes using a homogenizer. The obtained emulsion was stirred at 45°C for 4 hours, 5.20 parts of a 10% by mass of aqueous solution of 1,8-diazabicyclo[5.4.0]undeca-7-ene-octylate (U-CAT SA102, manufactured by San-Apro Ltd.) was added thereto, and the solution was stirred at room temperature for 30 minutes and allowed to stand at 45°C for 24 hours. Adjustment was made using distilled water so that the concentration of the solid content reached 20% by mass, thereby obtaining an aqueous dispersion liquid of a microgel (1). The average particle diameter was measured by a light scattering method and found out to be 0.28 µm.

### (Oil phase components)

(Component 1) ethyl acetate: 12.0 parts
(Component 2) adduct (50% by mass of ethyl acetate solution, manufactured by Mitsui Chemicals, Inc.) obtained by adding trimethylolpropane (6 mol equivalent) and xylene diisocyanate (18 mol equivalent) and adding methyl one-terminal polyoxyethylene (1 mol equivalent, repetition number of oxyethylene units: 90) thereto: 3.76 parts
(Component 3) polyvalent isocyanate compound (1) (as 50% by mass of ethyl acetate solution): 15.0 parts
(Component 4) 65% by mass of solution of dipentaerythritol pentaacrylate (SR-399, manufactured by Sartomer Japan Inc.) in ethyl acetate: 11.54 parts
(Component 5) 10% solution of sulfonate type surfactant (PIONINE A-41-C, manufactured by TAKEMOTO OIL & FAT Co., Ltd.) in ethyl acetate: 4.42 parts

### (Water phase component)

### Distilled water: 46.87 parts

### <Overcoat layer coating solution>

· Water-soluble polymer shown in Table 1: Amount shown in Table 1
· Particles shown in Table 1: Amount shown in Table 1
· Surfactant (RAPISOL A-80, manufactured by NOF Corporation): 0.01 parts by mass
· Water: Amount making the total 10 parts by mass

### [Evaluation]

### <On-press developability>

Each of the obtained lithographic printing plate precursors was exposed using Luxel PLATESETTER T-6000III (manufactured by Fujifilm Corporation) equipped with an infrared semiconductor laser under conditions of an external surface drum rotation speed of 1,000 rpm, a laser output of 70%, and a resolution of 2,400 dpi. The exposed image had a solid image and a 50% halftone dot chart of an FM screen having dots with a diameter of 20 µm.

The obtained exposed precursor was attached to a plate cylinder of a printing press LITHRONE26 (manufactured by KOMORI Corporation) without performing a development treatment. After the on-press development was performed by supplying dampening water and ink according to a standard automatic printing start method for LITHRONE26 using dampening water in which the volume ratio of Ecolity-2 (manufactured by Fujifilm Corporation) to tap water was 2:98 and Space color fusion G yellow ink (manufactured by DIC Graphics Corporation), printing was performed on 500 sheets of Tokubishi Art (manufactured by Mitsubishi Paper Mills, Ltd., ream weight: 76.5 kg) paper at a printing speed of 10,000 sheets per hour.

The on-press developability was measured based on the number of sheets of printing paper required for the on-press development of the unexposed area of the image recording layer on the printing press to be completed and for the ink not to be transferred to the non-image area.

### <On-press development scum-suppressing property>

The on-press developability evaluation was repeated three times using the same plate, the development scum adhering to a watered roller in the printing press was transferred to cellophane tape and attached to OK TOPCOAT paper (manufactured by Oji Paper Co., Ltd., model No. OK TOPCOAT+), and the cyan color density D(C) was measured using a color densitometer X-Rite (manufactured by X-Rite Inc).
Evaluation 1: D(C) is lower than 0.1.
Evaluation 2: D(C) is 0.1 or higher and lower than 0.3.
Evaluation 3: D(C) is 0.3 or higher and lower than 0.5.
Evaluation 4: D(C) is 0.5 or higher and lower than 1.0.
Evaluation 5: D(C) is 1.0 or higher.

### <Scratch resistance (scratch sensitivity)>

The scratch test was performed by applying a load of up to 100 g on a sapphire needle having a diameter of 0.1 mm starting from a load of 5 g by increasing 5 g each time using a scratch strength tester (manufactured by Shinto Scientific Co., Ltd.) and scanning the surface of each sample of the lithographic printing plate precursor, the load at the time of scratching was measured, and the presence of damage to the image area due to the scratches and occurrence of ink stains and development failure in the non-image area were visually observed.

The lithographic printing plate precursors of the respective examples and the respective comparative examples were placed in Kodak (registered trademark) Trendsetter 800II Quantum platesetter (exposure wavelength: 830 nm) and exposed using an infrared (IR) laser having a wavelength of 830 nm so that both an exposed image including a solid image and a 50% halftone dot chart of a 20 µm-dot frequency modulation (FM) screen and a non-image area were included in a scratched portion. The obtained exposed lithographic printing plate precursor was attached to the plate cylinder of the printing press LITHRONE26 (manufactured by KOMORI Corporation) without performing a development treatment. After the on-press development was performed by supplying dampening water and ink according to a standard automatic printing start method for LITHRONE26 using dampening water in which the volume ratio of Ecolity-2 (manufactured by Fujifilm Corporation) to tap water was 2:98 and Space color fusion G black ink (manufactured by DIC Graphics Corporation), printing was performed on 500 sheets of Tokubishi Art (manufactured by Mitsubishi Paper Mills, Ltd., ream weight: 76.5 kg) paper at a printing speed of 10,000 sheets per hour.

The maximum load on the obtained 500-th printed material at which a damage on the image area by scratches, poor development of the non-image area, or ink stains did not occur was evaluated as the following five levels.
Evaluation 1: The maximum load is 20 g or less.
Evaluation 2: The maximum load is more than 20 g and 40 g or less.
Evaluation 3: The maximum load is more than 40 g and 60 g or less.
Evaluation 4: The maximum load is more than 60 g and 80 g or less.
Evaluation 5: The maximum load is more than 80 g.

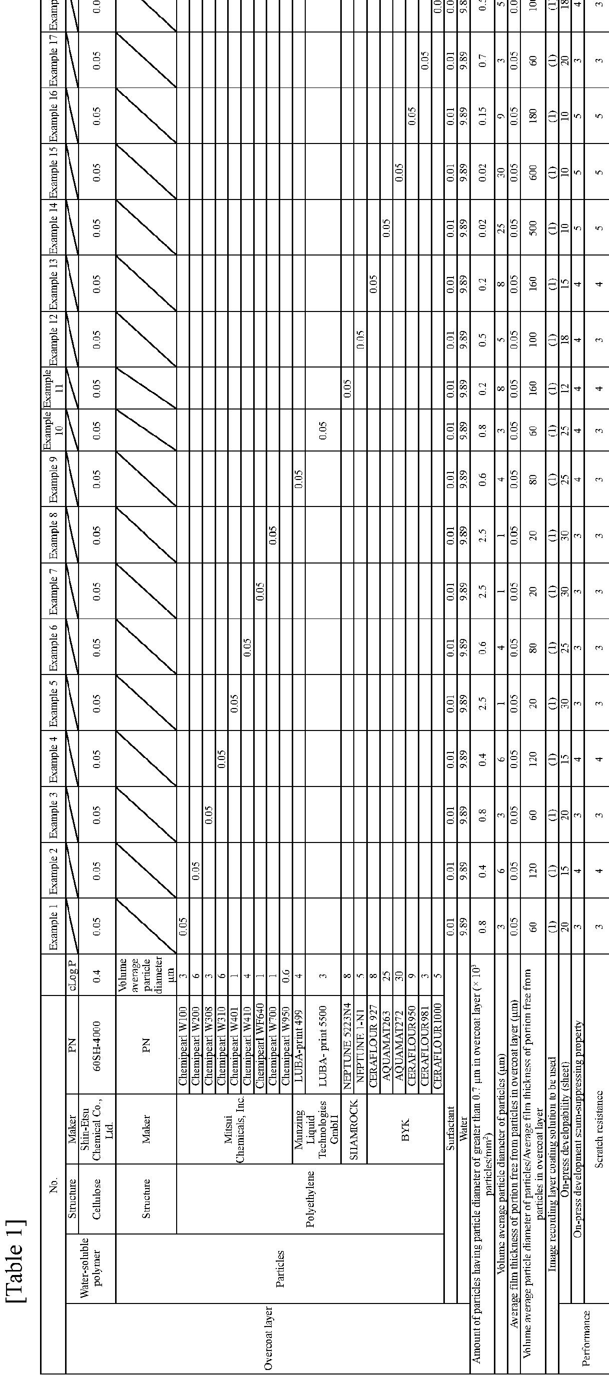

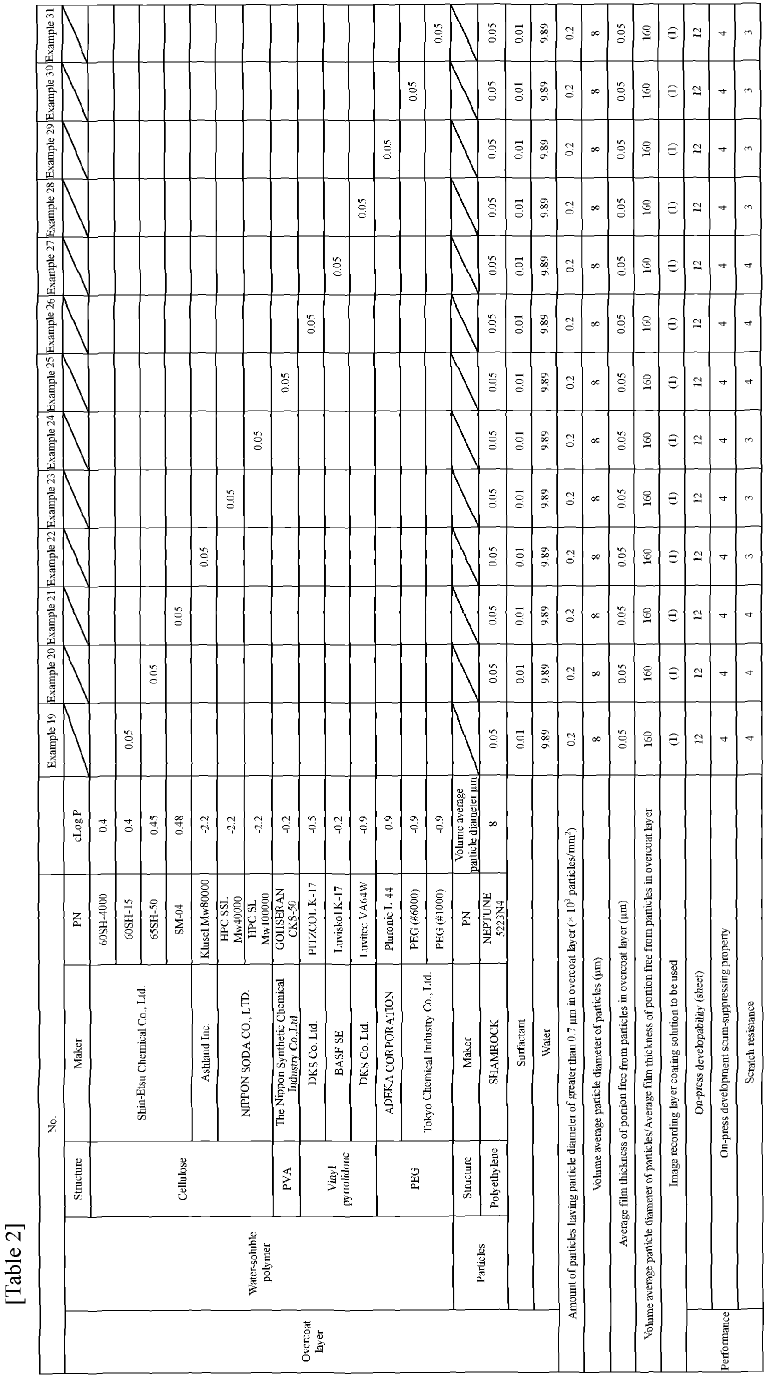

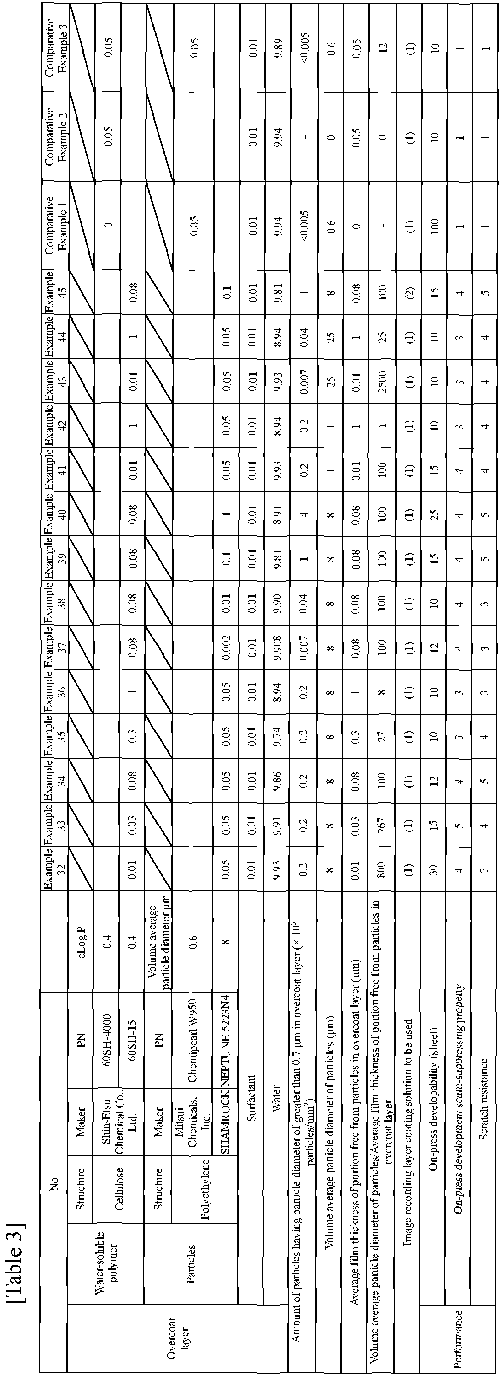

As is clear from the results of Table 1 to Table 3, compared with the comparative examples, it is found that the lithographic printing plate precursor according to the embodiment of the present disclosure has excellent scratch resistance and developability.

Further, it is found that the lithographic printing plate precursor according to the embodiment of the present disclosure also has an excellent on-press development scum-suppressing property.

### (Example 46 and Comparative Example 4)

### [Production of lithographic printing plate precursor]

### <Production of support E>

As a surface treatment, the following various treatments (a) to (i) were continuously performed using a 0.3 mm-thick aluminum plate (material JIS A 1050). Further, liquid cutting was performed using a nip roller after each treatment and washing with water.

### (a) Alkali etching treatment

The aluminum plate obtained in the above-described manner was subjected to an etching treatment by spraying an aqueous solution in which the concentration of caustic soda was 2.6% by mass and the concentration of aluminum ions was 6.5% by mass at a temperature of 70°C so that 6 g/m² of the aluminum plate was dissolved. Thereafter, washing with water by spraying was performed.

### (b) Desmutting treatment

A desmutting treatment was performed by spraying an aqueous solution (containing 0.5% by mass of aluminum ions) having a nitric acid concentration of 1% by mass at a temperature of 30°C. Thereafter, washing with water by spraying was performed. As the nitric acid aqueous solution used for the desmutting treatment, a waste liquid used for the step of performing the electrochemical roughening treatment using the alternating current in a nitric acid aqueous solution was used.

### (c) Electrochemical roughening treatment

An electrochemical roughening treatment was continuously performed using an AC voltage of 60 Hz. As an electrolyte at this time, an aqueous solution containing 10.5 g/L of nitric acid (containing 5 g/L of aluminum ions and 0.007% by mass of ammonium ions) was used, and the solution temperature was 50°C. Using a trapezoidal rectangular waveform AC having a time tp, until the current value reached a peak from zero, of 0.8 msec and the duty ratio of 1:1 as the AC power source waveform, the electrochemical roughening treatment was performed using a carbon electrode as a counter electrode. As an auxiliary anode, ferrite was used. The current density was 30 A/dm² as the peak current value, and the electric quantity was 220 C/dm² as the sum total of electric quantity at the time of anodization of the aluminum plate. 5% of the current from the power source was separately flowed to the auxiliary anode. Thereafter, washing with water by spraying was performed.

### (d) Alkali etching treatment

The aluminum plate was subjected to an etching treatment by spraying an aqueous solution in which the concentration of caustic soda was 26% by mass and the concentration of aluminum ions was 6.5% by mass at a temperature of 32°C so that 0.25 g/m² of the aluminum plate was dissolved. Further, a smut component mainly containing aluminum hydroxide generated at the time of the electrochemical roughening treatment using the alternating current at the former step was removed, and an edge portion of a generated pit was dissolved to smooth the edge portion. Thereafter, washing with water by spraying was performed.

### (e) Desmutting treatment

A desmutting treatment was performed by spraying an aqueous solution (containing 4.5% by mass of aluminum ions) having a sulfuric acid concentration of 15% by mass at a temperature of 30°C. Thereafter, washing with water was performed using a spray. As the nitric acid aqueous solution used for the desmutting treatment, a waste liquid used for the step of performing the electrochemical roughening treatment using the alternating current in a nitric acid aqueous solution was used.

### (f) Electrochemical roughening treatment

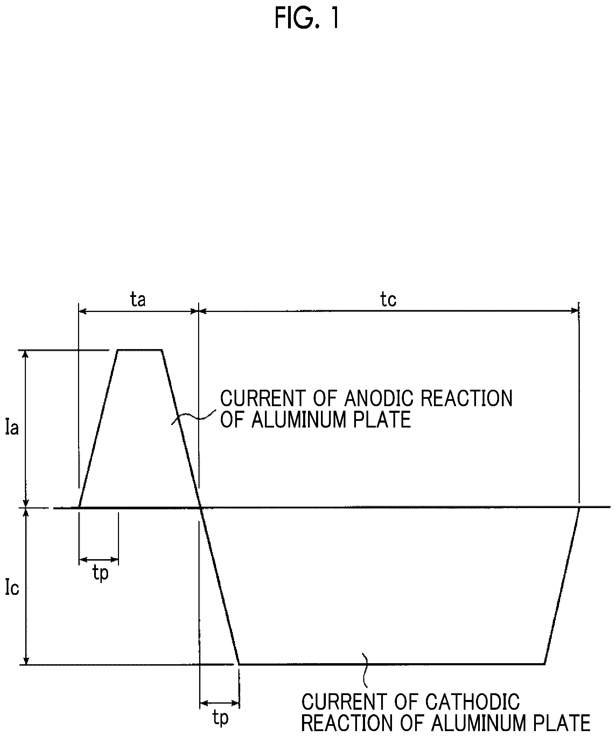

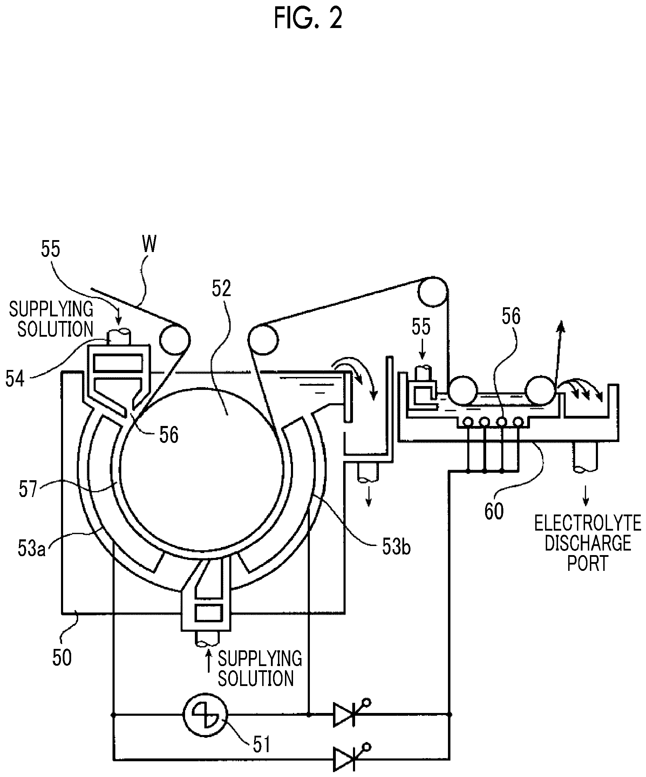

An electrochemical roughening treatment was continuously performed using an AC voltage of 60 Hz. As an electrolyte at this time, an aqueous solution containing 2.5 g/L of hydrochloric acid (containing 5 g/L of aluminum ions) was used, and the temperature was 35°C. Using a trapezoidal rectangular waveform AC having a time tp, until the current value reached a peak from zero, of 0.8 msec and the duty ratio of 1:1 as an AC power source waveform which is a waveform shown in Fig. 1, the electrochemical roughening treatment was performed using a carbon electrode as a counter electrode. As an auxiliary anode, ferrite was used. As an electrolytic cell to be used, the electrolytic cell shown in Fig. 2 was used. The current density was 25 A/dm² as the peak current value, and the electric quantity was 50 C/dm² as the sum total of electric quantity at the time of anodization of the aluminum plate. Thereafter, washing with water by spraying was performed.

### (g) Alkali etching treatment

The aluminum plate was subjected to an etching treatment by spraying an aqueous solution in which the concentration of caustic soda was 26% by mass and the concentration of aluminum ions was 6.5% by mass at a temperature of 32°C so that 0.1 g/m² of the aluminum plate was dissolved. Further, a smut component mainly containing aluminum hydroxide generated at the time of the electrochemical roughening treatment using the alternating current at the former step was removed, and an edge portion of a generated pit was dissolved to smooth the edge portion. Thereafter, washing with water by spraying was performed.

### (h) Anodizing treatment

2.5 g/m² of a DC anodized film was formed on the aluminum plate at a current density of 15 A/dm² using a 15% by mass aqueous solution of sulfuric acid (including 0.5% by mass of aluminum ions) as an electrolyte and then washed with water and dried, thereby producing a support C. The average pore diameter in the surface layer of the anodized film (surface average pore diameter) was 10 nm.

The pore diameter in the surface layer of the anodized film was measured using a method in which the surface was observed an ultrahigh resolution SEM (S-900 manufactured by Hitachi, Ltd.) at a relatively low acceleration voltage of 12 V at a magnification of 150,000 times without carrying out a vapor deposition treatment or the like for imparting conductive properties, 50 pores were randomly extracted, and the average value was obtained. The standard deviation error was ± 10% or less of the average value.

### (i) Hydrophilization treatment

Thereafter, in order to ensure hydrophilicity of the non-image area, the support C was subjected to a silicate treatment at 60°C for 10 seconds using a 2.5% by mass of a No. 3 sodium silicate aqueous solution and then washed with water, thereby producing a support E. The adhesion amount of Si was 9.5 mg/m². The center line average roughness (Ra) of the support E was measured using a needle having a diameter of 2 µm and found out to be 0.27 µm.

### <Formation of undercoat layer>

The support E was coated with an undercoat layer coating solution (2) having the following composition such that a dried coating amount was set to 20 mg/m², thereby forming an undercoat layer.

### (Undercoat layer coating solution (2))

· Polymer (P-2) (resin having the following structure, Mw: 100,000): 0.18 parts
· Tetrasodium ethylenediaminetetraacetate: 0.10 parts
· Polyoxyethylene lauryl ether: 0.03 parts
· Water: 61.39 parts

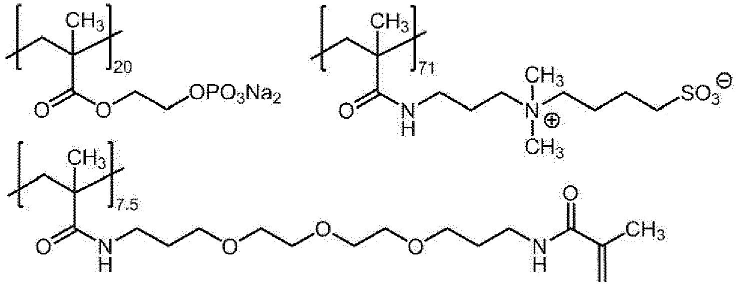

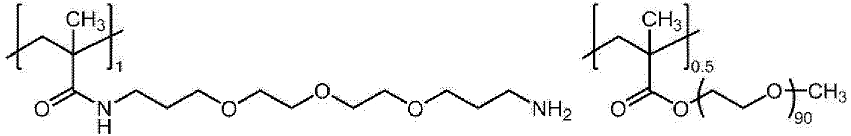

The numerical values on the lower right side of the parentheses of each constitutional unit in the above-described compound (2) for an undercoat layer indicate the mass ratios, and the numerical values on the lower right side of the parentheses of each ethyleneoxy unit indicate the repetition numbers.

### <Formation of image recording layer>

The undercoat layer on the support E formed as described above was bar-coated with an image recording layer coating solution (3) having the following composition and dried in an oven at 100°C for 60 seconds, thereby forming an image recording layer having a dried coating amount of 1.0 g/m².

The image recording layer coating solution (1) was obtained by mixing the photosensitive solution (1) described below and the microgel solution (1) immediately before the coating and then stirring the solution.

### <Photosensitive solution (1)>

· Binder polymer (2) [the following structure]: 0.240 parts
· Infrared absorbent (2): 0.024 parts
· Polymerization initiator (1): 0.245 parts
· Polymerizable compound (Tris(acryloyloxyethyl) isocyanurate, NK ESTER A-9300, manufactured by Shin-Nakamura Chemical Co., Ltd.): 0.192 parts
· Colorant ethyl violet [the following structure]: 0.030 parts
· Fluorine-based surfactant (1): 0.008 parts
· 2-butanone: 1.091 parts
· 1-methoxy-2-propanol: 8.609 parts

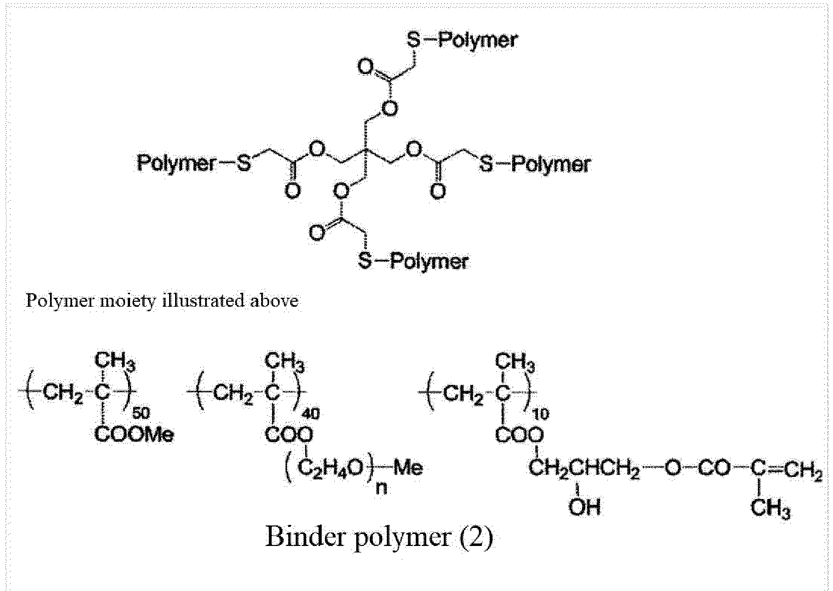

Further, Me represents a methyl group, and the numerical values on the lower right side of the parentheses of each constitutional unit in the binder polymer (2) indicate the molar ratios.

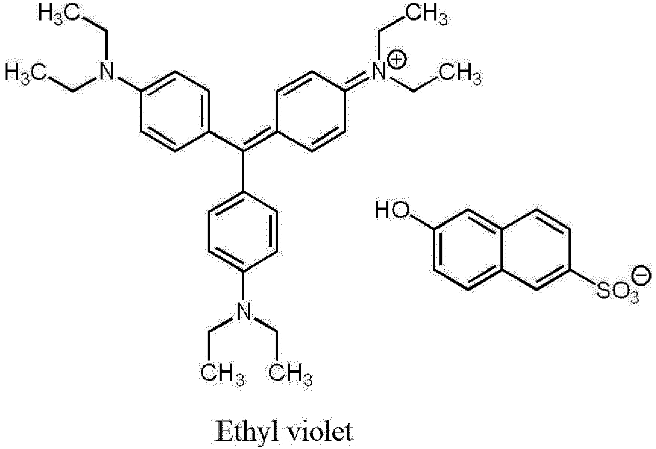

### <Formation of overcoat layer>

The image recording layer was further bar-coated with a coating solution obtained by changing the overcoat layer coating solution to a composition shown in Table 4 and dried in an oven at 120°C for 60 seconds, thereby forming an overcoat layer having a dried coating amount of 0. 1 g/m² and thus obtaining a lithographic printing plate precursor.

### [Evaluation of lithographic printing plate precursor]

For the respective lithographic printing plate precursor described above, developability and scratch resistance were evaluated using the following evaluation methods.

### [Image exposure]

The lithographic printing plate precursor was exposed using a Luxel PLATESETTER T-6000III manufactured by Fujifilm Corporation equipped with an infrared semiconductor laser under conditions of an external surface drum rotation speed of 1,000 rpm, a laser output of 70%, and a resolution of 2,400 dpi. The exposed image had a solid image and a 50% halftone dot chart.

### [Development treatment]

On the exposed lithographic printing plate, a development treatment was performed at 25°C for 20 seconds using Clean Out Unit+ C85 manufactured by Glunz & Jensen.

Here, "development treatment" refers to a complex treatment including, in addition to the development of the image forming layer, one or more treatments selected from the group consisting of the removal of the overcoat layer, gum pulling, and drying. As a treatment liquid used for the development treatment, a solution having the following composition was used.

### <Developer>

· PELEX NBL (sodium alkylnaphthalenesulfonate, anionic surfactant manufactured by Kao Corporation): 7.8 parts by mass
· NEWCOL B13 (polyoxyethylene aryl ether, non-ionic surfactant manufactured by Nippon Nyukazai Co., Ltd.): 2.00 parts by mass
· SURFYNOL 2502 (manufactured by Air Products and Chemicals, Inc.): 0.6 parts by mass
· Benzyl alcohol (manufactured by Wako Pure Chemical Industries Ltd.): 0.8 parts by mass
· Sodium gluconate (manufactured by Fuso Chemical Co., Ltd.): 3.0 parts by mass
· Disodium hydrogen phosphate (manufactured by Wako Pure Chemical Industries Ltd.): 0.3 parts by mass
· Sodium bicarbonate (manufactured by Wako Pure Chemical Industries Ltd.): 0.3 parts by mass
· Antifoaming agent (SILCOLAPSE432 manufactured by Bluestar Silicones USA Corp.): 0.01 parts by mass
· Water: 85.49 parts by mass

### <Developability>

On the respective lithographic printing plate precursor, exposure and the development treatment were performed as described above, the remaining of the image recording layer in a non-image area of the obtained lithographic printing plate was visually confirmed, and the developability was evaluated. The evaluation was performed using the following standards. Evaluations 2 and 3 are permissible levels.
Evaluation 3: The image recording layer does not remain.
Evaluation 2: The image recording layer slightly remains, but there is no problem with the developability.
Evaluation 1: The image recording layer remains, and the developability is poor.

### <Scratch resistance (scratch sensitivity)>

The scratch test was performed by applying a load of up to 100 g on a sapphire needle having a diameter of 0.1 mm starting from a load of 5 g by increasing 5 g each time using a scratch strength tester (manufactured by Shinto Scientific Co., Ltd.) and scanning the surface of each sample of the lithographic printing plate precursor, the load at the time of scratching was measured, and the presence of damage to the image area due to the scratches and occurrence of ink stains and development failure in the non-image area were visually observed.

The lithographic printing plate precursors of the respective examples and the respective comparative examples were placed in the exposure machine and exposed using an infrared (IR) laser having a wavelength of 830 nm so that both an exposed image including a solid image and a 50% halftone dot chart of a 20 µm-dot frequency modulation (FM) screen and a non-image area were included in a scratched portion. After the development treatment on the obtained exposed lithographic printing plate precursor, the plate precursor was attached to the plate cylinder of the printing press LITHRONE26 manufactured by Komori Corporation. After supplying dampening water and ink according to a standard automatic printing start method for LITHRONE26 using dampening water in which the volume ratio of Ecolity-2 (manufactured by Fujifilm Corporation) to tap water was 2:98 and Space color fusion G black ink (manufactured by DIC Graphics Corporation), printing was performed on 500 sheets of Tokubishi Art (manufactured by Mitsubishi Paper Mills, Ltd., ream weight: 76.5 kg) paper at a printing speed of 10,000 sheets per hour.

The maximum load on the obtained 500-th printed material at which a damage on the image area by scratches, poor development of the non-image area, or ink stains did not occur was evaluated as the following five levels.
Evaluation 1: The maximum load is 20 g or less.
Evaluation 2: The maximum load is more than 20 g and 40 g or less.
Evaluation 3: The maximum load is more than 40 g and 60 g or less.
Evaluation 4: The maximum load is more than 60 g and 80 g or less.
Evaluation 5: The maximum load is more than 80 g.

**[Table 4]**

| No. | | | | | | Example 46 | Comparative Example 4 |
|---|---|---|---|---|---|---|---|
| Overcoat layer | Water-soluble polymer | Structure | Maker | PN | cLog P | | |
| | | Cellulose | Shin-Etsu Chemical Co., Ltd. | 60SH-4000 | 0.4 | 0.05 | 0.05 |
| | Particles | Structure | Maker | PN | Volume average particle diameter µm | | |
| | | Polyethylene | Mitsui Chemicals, Inc. | Chemipearl W950 | 0.6 | | 0.05 |
| | | | BYK | AQUAMAT27 2 | 30 | 0.05 | |
| | Surfactant | | | | | 0.01 | 0.01 |
| | Water | | | | | 9.89 | 9.89 |
| Amount of particles having particle diameter of greater than 0.7 µm in overcoat layer (× 10³ particles/mm²) | | | | | | 0.02 | <0.005 |
| Volume average particle diameter of particles (µm) | | | | | | 30 | 0.6 |
| Average film thickness of portion free from particles in overcoat layer (µm) | | | | | | 0.05 | 0.05 |
| Volume average particle diameter of particles/Average film thickness of portion free from particles in overcoat layer | | | | | | 600 | 12 |
| Image recording layer coating solution to be used | | | | | | (3) | (3) |
| Performance | Developability | | | | | 3 | 1 |
| | Scratch resistance | | | | | 5 | 1 |

As is clear from the results of Table 4, compared with the comparative examples, it is found that the lithographic printing plate precursor according to the embodiment of the present disclosure has excellent scratch resistance and developability.

### Explanation of References

ta: anodic reaction time,
tc: cathodic reaction time,
tp: time taken for current to reach peak from zero,
Ia: current at peak on anode cycle side,
Ic: current at peak on cathode cycle side,
50: main electrolytic cell,
51: AC power source,
52: radial drum roller,
53a, 53b: main pole,
54: electrolyte supply port,
55: electrolyte,
56: auxiliary anode,
60: auxiliary anode cell,
W: aluminum plate

## Claims

1. An on-press development type lithographic printing plate precursor comprising:
a support;
an image recording layer; and
an overcoat layer in this order,
wherein the image recording layer includes an infrared absorbent, a polymerizable compound, and a polymerization initiator,
the overcoat layer includes a water-soluble polymer and particles,
a melting point of the particles is in a range of 70°C to 150°C, and
a volume average particle diameter of the particles is greater than 0.7 µm,
wherein the water-soluble polymer is a polymer compound that dissolves as much as 1 g or more in 100 g of water at 25°C and polymer refers to a compound having a weight-average molecular weight of 1,000 or greater.

2. The on-press development type lithographic printing plate precursor according to claim 1,
wherein the overcoat layer contains 10,000 particles/mm² or greater of the particles having a volume average particle diameter of greater than 0.7 µm.

3. The on-press development type lithographic printing plate precursor according to claim 1 or 2,
wherein a surface of an outermost layer on the image recording layer side in the lithographic printing plate precursor is formed of the particles and the water-soluble polymer.

4. The on-press development type lithographic printing plate precursor according to any one of claims 1 to 3,
wherein an area ratio occupied by the particles in a surface of an outermost layer on the image recording layer side in the lithographic printing plate precursor is 20% or less.

5. The on-press development type lithographic printing plate precursor according to any one of claims 1 to 4,
wherein an average film thickness of a portion free from the particles in the overcoat layer is smaller than the volume average particle diameter of the particles.

6. The on-press development type lithographic printing plate precursor according to any one of claims 1 to 5,
wherein a value of the volume average particle diameter of the particles/an average film thickness of a portion free from the particles in the overcoat layer is 10 or greater.

7. The on-press development type lithographic printing plate precursor according to any one of claims 1 to 6,
wherein the particles are organic resin particles.

8. The on-press development type lithographic printing plate precursor according to any one of claims 1 to 7,
wherein the particles contain at least one particle selected from the group consisting of polyethylene particles and modified polyethylene particles.

9. The on-press development type lithographic printing plate precursor according to any one of claims 1 to 8,
wherein the water-soluble polymer includes a cellulose compound.

10. The on-press development type lithographic printing plate precursor according to any one of claims 1 to 9,
wherein the image recording layer further includes a polymer compound having a particle shape.

11. A method of producing a lithographic printing plate, comprising:
a step of image-wise exposing the lithographic printing plate precursor according to any one of claims 1 to 10 to form an exposed area and an unexposed area; and
a step of supplying at least one of printing ink or dampening water to remove a non-image area.

## Patentansprüche

1. Lithographiedruckplattenvorläufer vom Typ zur Entwicklung auf der Presse, umfassend in dieser Reihenfolge:
einen Träger;
eine Bildaufzeichnungsschicht; und
eine Überzugsschicht;
worin die Bildaufzeichnungsschicht einen Infrarotabsorber, eine polymerisierbare Verbindung und einen Polymerisationsinitiator umfasst,
die Überzugsschicht ein wasserlösliches Polymer und Partikel umfasst,
der Schmelzpunkt der Partikel im Bereich von 70°C bis 150°C liegt und
der volumengemittelte Partikeldurchmesser der Partikel größer als 0,7 µm ist,
worin das wasserlösliche Polymer eine Polymerverbindung ist, die sich bei 25°C in einer Menge von 1 g oder mehr in 100 g Wasser löst, und worin sich der Ausdruck "Polymer" auf eine Verbindung mit einem gewichtsgemittelten Molekulargewicht von 1.000 oder größer bezieht.

2. Lithographiedruckplattenvorläufer vom Typ zur Entwicklung auf der Presse gemäß Anspruch 1,
worin die Überzugsschicht 10.000 Partikel/mm² oder mehr der Partikel mit einem volumengemittelten Partikeldurchmesser von größer als 0,7 µm umfasst.

3. Lithographiedruckplattenvorläufer vom Typ zur Entwicklung auf der Presse gemäß Anspruch 1 oder 2,
worin eine Oberfläche einer äußersten Schicht auf der Seite der Bildaufzeichnungsschicht in dem Lithographiedruckplattenvorläufer aus den Partikeln und dem wasserlöslichen Polymer gebildet ist.

4. Lithographiedruckplattenvorläufer vom Typ zur Entwicklung auf der Presse gemäß irgendeinem der Ansprüche 1 bis 3,
worin im Lithographiedruckplattenvorläufer der von den Partikeln in einer Oberfläche einer äußersten Schicht auf der Seite der Bildaufzeichnungsschicht eingenommene Flächenanteil 20 % oder weniger beträgt.

5. Lithographiedruckplattenvorläufer vom Typ zur Entwicklung auf der Presse gemäß irgendeinem der Ansprüche 1 bis 4,
worin die mittlere Filmdicke eines Bereichs in der Überzugsschicht, der keine Partikel aufweist, kleiner ist als der volumengemittelte Partikeldurchmesser der Partikel.

6. Lithographiedruckplattenvorläufer vom Typ zur Entwicklung auf der Presse gemäß irgendeinem der Ansprüche 1 bis 5,
worin der Wert volumengemittelter Partikeldurchmesser der Partikel/ mittlere Filmdicke eines Bereichs in der Überzugschicht, der keine Partikel aufweist, 10 oder größer ist.

7. Lithographiedruckplattenvorläufer vom Typ zur Entwicklung auf der Presse gemäß irgendeinem der Ansprüche 1 bis 6,
worin die die Partikel organische Harzpartikel sind.

8. Lithographiedruckplattenvorläufer vom Typ zur Entwicklung auf der Presse gemäß irgendeinem der Ansprüche 1 bis 7,
worin die Partikel mindestens einen Partikel enthalten, der ausgewählt ist aus der Gruppe bestehend aus Polyethylenpartikeln und modifizierten Polyethylenpartikeln.

9. Lithographiedruckplattenvorläufer vom Typ zur Entwicklung auf der Presse gemäß irgendeinem der Ansprüche 1 bis 8,
worin das wasserlösliche Polymer eine Celluloseverbindung umfasst.

10. Lithographiedruckplattenvorläufer vom Typ zur Entwicklung auf der Presse gemäß irgendeinem der Ansprüche 1 bis 9,
worin die Bildaufzeichnungsschicht ferner eine Polymerverbindung mit einer Partikelform umfasst.

11. Verfahren zur Herstellung einer Lithographiedruckplatte, umfassend:
einen Schritt zur bildweisen Belichtung des Lithographiedruckplattenvorläufers gemäß irgendeinem der Ansprüche 1 bis 10, um einen belichteten Bereich und einen nicht-belichteten Bereich zu bilden; und
einen Schritt zum Zuführen von zumindest einem von Drucktinte oder Anfeuchtwasser, um einen Nicht-Bildbereich zu entfernen.

## Revendications

1. Précurseur de plaque d'impression lithographique de type développement sur presse comprenant : un support ;
une couche d'enregistrement d'image ; et
une couche de finition, dans cet ordre,
dans lequel la couche d'enregistrement d'image inclut un agent absorbant les infrarouges, un composé polymérisable, et un initiateur de polymérisation,
la couche de finition inclut un polymère hydrosoluble et des particules,
un point de fusion des particules se situe dans une plage de 70 °C à 150 °C, et
un diamètre de particule moyen en volume des particules est supérieur à 0,7 µm,
dans lequel le polymère hydrosoluble est un composé polymère qui se dissout jusqu'à 1 g ou plus dans 100 g d'eau à 25°C et polymère se rapporte à un composé présentant un poids moléculaire moyen en poids supérieur ou égale à 1 000.

2. Précurseur de plaque d'impression lithographique de type développement sur presse selon la revendication 1,
dans lequel la couche de finition contient 10 000 particules/mm² ou plus des particules présentant un diamètre de particule moyen en volume supérieur à 0,7 µm.

3. Précurseur de plaque d'impression lithographique de type développement sur presse selon la revendication 1 ou 2,
dans lequel une surface d'une couche extérieure sur le côté couche d'enregistrement d'image dans le précurseur de plaque d'impression lithographique est composée des particules et du polymère hydrosoluble.

4. Précurseur de plaque d'impression lithographique de type développement sur presse selon l'une quelconque des revendications 1 à 3,
dans lequel un rapport de zone occupé par les particules dans une surface d'une couche extérieure sur le côté couche d'enregistrement d'image dans le précurseur de plaque d'impression lithographique est inférieur ou égal à 20 %.

5. Précurseur de plaque d'impression lithographique de type développement sur presse selon l'une quelconque des revendications 1 à 4,
dans lequel une épaisseur moyenne de film d'une partie exempte des particules dans la couche de finition est inférieure au diamètre de particule moyen en volume des particules.

6. Précurseur de plaque d'impression lithographique de type développement sur presse selon l'une quelconque des revendications 1 à 5,
dans lequel une valeur du diamètre de particule moyen en volume des particules/une épaisseur moyenne de film d'une partie exempte des particules dans la couche de finition est supérieure ou égale à 10.

7. Précurseur de plaque d'impression lithographique de type développement sur presse selon l'une quelconque des revendications 1 à 6,
dans lequel les particules sont des particules de résine organique.

8. Précurseur de plaque d'impression lithographique de type développement sur presse selon l'une quelconque des revendications 1 à 7,
dans lequel les particules contiennent au moins une particule sélectionnée dans le groupe consistant en des particules de polyéthylène et des particules de polyéthylène modifié.

9. Précurseur de plaque d'impression lithographique de type développement sur presse selon l'une quelconque des revendications 1 à 8,
dans lequel le polymère hydrosoluble inclut un composé cellulosique.

10. Précurseur de plaque d'impression lithographique de type développement sur presse selon l'une quelconque des revendications 1 à 9,
dans lequel la couche d'enregistrement d'image inclut en outre un composé polymère présentant une forme particulaire.

11. Procédé de production d'une plaque d'impression lithographique, comprenant :
une étape d'exposition image par image du précurseur de plaque d'impression lithographique selon l'une quelconque des revendications 1 à 10 pour former une zone exposée et une zone non exposée ; et
une étape de fourniture d'au moins une parmi une encre d'impression ou une eau de mouillage pour retirer une zone sans image.
